(19) **Europäisches Patentamt**
**European Patent Office**
**Office européen des brevets**

(11) **EP 1 321 963 B1**

(12) **EUROPEAN PATENT SPECIFICATION**

(45) Date of publication and mention
of the grant of the patent:
**18.04.2007 Bulletin 2007/16**

(51) Int Cl.:
***H01J 37/32*** *(2006.01)*

(21) Application number: **02028525.0**

(22) Date of filing: **19.12.2002**

(54) **Plasma processing method and plasma processing apparatus**

Verfahren und Vorrichtung zur Plasmabearbeitung

Procédé et appareil de traitement par plasma

(84) Designated Contracting States:
**DE FR GB IT**

(30) Priority: **20.12.2001 JP 2001388048**
　　　　　　**20.12.2001 JP 2001388047**
　　　　　　**17.12.2002 JP 2002365144**
　　　　　　**17.12.2002 JP 2002365145**

(43) Date of publication of application:
**25.06.2003 Bulletin 2003/26**

(73) Proprietor: **CANON KABUSHIKI KAISHA**
**Tokyo (JP)**

(72) Inventors:
 • **Murayama, Hitoshi**
　**Ohta-ku,**
　**Tokyo (JP)**
 • **Ueda, Shigenori**
　**Ohta-ku,**
　**Tokyo (JP)**
 • **Tsuchida, Shinji**
　**Ohta-ku,**
　**Tokyo (JP)**

 • **Aoki, Makoto**
　**Ohta-ku,**
　**Tokyo (JP)**
 • **Ozawa, Tomohito**
　**Ohta-ku,**
　**Tokyo (JP)**

(74) Representative: **TBK-Patent**
**Bavariaring 4-6**
**80336 München (DE)**

(56) References cited:
　**US-A- 5 936 481**　　**US-B1- 6 313 584**

 • **PATENT ABSTRACTS OF JAPAN vol. 1996, no. 08, 30 August 1996 (1996-08-30) & JP 08 096992 A (NISSIN ELECTRIC CO LTD), 12 April 1996 (1996-04-12)**
 • **PATENT ABSTRACTS OF JAPAN vol. 1998, no. 02, 30 January 1998 (1998-01-30) & JP 09 260096 A (HITACHI LTD;HITACHI TOKYO ELECTRON CO LTD), 3 October 1997 (1997-10-03)**

EP 1 321 963 B1

**Description**

BACKGROUND OF THE INVENTION

Field of the Invention

The present invention relates to a plasma processing method and a plasma processing apparatus using the high frequency power for use in formation of a deposition film and etching in a semiconductor device, an electrophotographic photosensitive member, a line sensor for image input, a photographing device, a photovoltaic device or the like, or for use in cleaning and the like in a plasma processing apparatus after formation of a deposition film. Related Background Art

Conventionally, as a deposition film formation process used to produce a semiconductor device, an electrophotographic photosensitive member, a line sensor for image input, a photographing device, a photovoltaic device, or other electronic or optical element, many types of methods have been known, such as vacuum deposition, sputtering, ion plating, thermal CVD (Chemical Vapor Deposition), photo-assisted CVD and plasma CVD, and apparatuses for the methods have been put to practical use.

Among them, a plasma CVD method, which provides a thin deposition film formed on a substrate by using a direct current, high-frequency, or microwave glow discharge to decompose a raw material gas, is now increasingly put to practical use as a suitable measure for forming a deposition film of amorphous silicon hydride (hereinafter referred to as "a-Si:H") for electrophotograph, and various kinds of apparatus used for the method have been proposed.

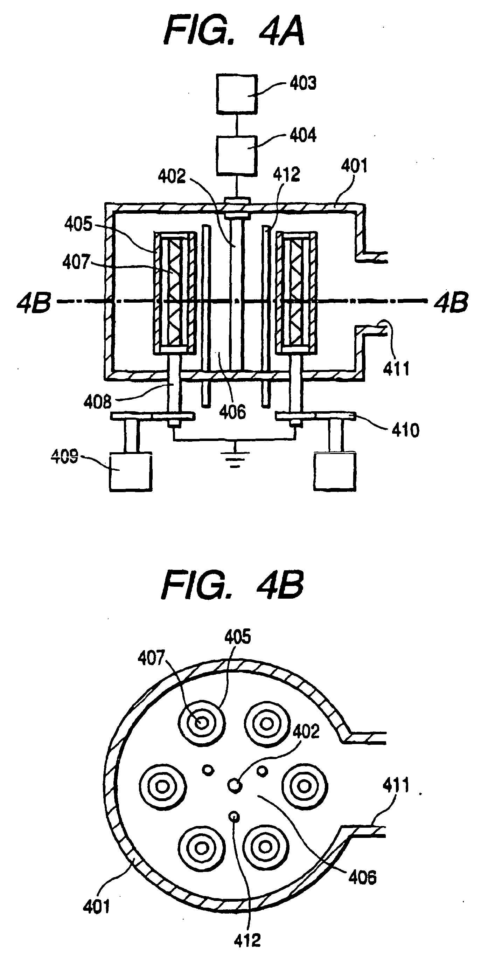

In addition, among plasma CVD processes, VHF plasma CVD (abbreviated as "VHF-PCVD" hereinafter) using the VHF-band high frequency power has attracted attention in recent years, and development for formation of various kinds of deposition films using this process is being vigorously conducted. This is because VHF-PCVD enables a film to be deposited at high speed and provides a high quality deposition film, and is thus looked upon as a process capable of achieving reduction in costs and enhancement of quality of products at the same time. For example, Japanese Patent Application Laid-Open No. 6-287760 (corresponding to U.S. Patent No. 5,534,070) discloses an apparatus and a method that can be used for forming an amorphous silicon (a-Si) based light-receiving member for electrophotography. Also, plasma processing apparatuses as shown in FIGS. 4A and 4B and FIGS. 6A and 68, which can form a plurality of light-receiving members for electrophotography at the same time and thus achieve very high productivity, are under development.

FIG. 4A is a schematic sectional view of a conventional plasma processing apparatus, and FIG. 4B is a schematic sectional view taken along a cutting plane line 4B-4B of FIG. 4A. An exhaust pipe 411 is provided on the side face of a reactor container 401 as one united body, and the other end of the exhaust pipe 411 is connected to an exhausting system (not shown). Six cylindrical substrates 405 on which deposition films are to be formed are disposed in parallel to one another in such a manner as to surround the central portion of the reactor container 401. Each cylindrical substrate 405 is supported by a rotation shaft 408, and is heated by a heating element 407. When a motor 409 is driven, the rotation shaft 408 is rotated via a reduction gear 410, and the cylindrical substrate 405 is rotated around the central axis in the generatrix line direction thereof (central axis along the lengthwise direction of the cylindrical substrate).

A raw material gas is supplied to a film formation space 406 surrounded by six cylindrical substrates 405 from raw material gas supplying means 412. The VHF power that is a high frequency power is supplied to the film formation space 406 from a high frequency power supply 403 through a matching device (hereinafter referred to as a matching box) 404 and then a cathode 402. At this time, the cylindrical substrate 405 kept at a ground potential through the rotation shaft 408 serves as an anodic electrode.

Formation of deposition films using such an apparatus can generally be performed according to the procedure described below.

First, the cylindrical substrates 405 are installed in the reactor container 401, and gas is exhausted from the reactor container 401 by an exhausting system (not shown) via the exhaust pipe 411. Subsequently, the cylindrical substrates 405 are heated by the heating element 407 while control is performed so that they are kept at a predetermined temperature of about 200 to 300°C.

When the temperature of the cylindrical substrate 405 reaches a predetermined temperature, the raw material gas is introduced into the reactor container 401 through the raw material gas supplying means 412. Also, after it is checked that the pressure in the reactor container 401 is stabilized, and the output of the high frequency power supply 403 is set at a predetermined value. Subsequently, the impedance of a matching circuit in the matching box 404 is adjusted so that the output impedance of the high frequency power supply 403 equals the impedance of the inlet of the matching box 404. In this way, the VHF power that is a high frequency power is efficiently supplied to the reactor container 401 through the high frequency electrode 402, a glow discharge is produced in the film formation space 406 surrounded by the cylindrical substrates 405, and the raw material gas is excited and dissociated to form a deposition film on the cylindrical substrates 405.

After a film having a desired thickness is formed, supply of VHF power is stopped, and subsequently supply of the raw material gas is stopped to complete the forming of the deposition film. By repeating the same operation several times, a desired multilayered light-receiving layer of multi-layer structure can be formed.

During formation of the deposition film, the cylindrical substrate 405 is rotated at a predetermined speed with the motor 409 via the rotation shaft 408 to form the deposition film over the entire surface of the cylindrical substrate.

In this formation of a deposition film, the impedance adjustment of the matching circuit in the matching box 404 is performed manually or automatically. In the case of automatic adjustment, the matching box 404 comprises therein a system including a matching circuit 501 and a control system 500. The matching circuit 501 is constituted of a matching variable condenser 502, a tuning variable condenser 503 and a coil 504, and at the inlet of the matching circuit 501, a high frequency current is detected by a current detection element 505, and a high frequency voltage is detected by a voltage detection element 506. The outputs of the current detection element 505 and the voltage detection element 506 are inputted in a phase difference detector 507 and an impedance detector 508 in the control system 500. In the phase difference detector 507, the phase of impedance at the inlet of the matching circuit 501 is detected, and a voltage consistent with the phase of impedance is outputted to a tuning control circuit 509. In the tuning control circuit 509, the voltage inputted from the phase difference detector 507 is compared with a reference voltage, and a voltage consistent with the difference therebetween is supplied to a motor 510 for driving the tuning variable condenser 503. As a result, the tuning variable condenser 503 is adjusted by the motor 510 so that the phase of impedance satisfies a predetermined matching goal condition, for example, the phase equals 0. On the other hand, in the impedance detector 508, the absolute value of impedance at the inlet of the matching circuit 501 is detected, and a voltage consistent with the absolute value of impedance is outputted to a matching control circuit 511. In the matching control circuit 511, the voltage inputted from the impedance detector 508 is compared with the reference voltage, and a voltage consistent with the difference therebetween is supplied to a motor 512 for driving the matching variable condenser 502. As a result, the matching variable condenser 502 is adjusted by the motor 512 so that the absolute value of impedance satisfies a predetermined matching goal condition, for example, the absolute value of impedance equals 50 Ω. In this configuration, the impedance adjustment is automatically performed, and thus the high frequency power is efficiently supplied to the reactor container 501.

For further improving vacuum processing characteristics, a technique is under development in which a plurality of powers of different frequencies are supplied to the reactor container at the same time. For example, Japanese Patent Application Laid-Open No. 11-191554 discloses a technique in which a first high frequency power having a frequency of 300 MHz to 1,000 MHz and a second high frequency power having a frequency of 50 kHz to 30 MHz are supplied to the same electrode at the same time, and this technique reportedly allows active specie control effects to be enhanced, thus making it possible to carry out accurate plasma processing. Also, Japanese Patent Application Laid-Open No. 7-74159 discloses a technique in which a 60 MHz high frequency power and a 400 kHz low frequency power are supplied to the same electrode with one power superimposed on the other, and this technique reportedly enables a self bias to be controlled stably, thus making it possible to improve an etching rate and curb the occurrence of particles.

For supplying a plurality of high frequency powers to the reactor container, an independent matching device is provided in each high frequency power supply system to adjust the impedance of the matching device for each high frequency power supply system, whereby the high frequency power is supplied to the reactor container efficiently. Specifically, impedance adjustment is carried out in the same way as the case where a single high frequency power is supplied.

In this way, the vacuum processing method in which a plurality of powers of different frequencies are supplied to the reactor container at the same time provide a variety of actions depending on influences of employed frequencies and power ratios or specific procedures of vacuum processing, and it is expected that those actions will play an important role to improve the vacuum processing characteristics by using those actions effectively.

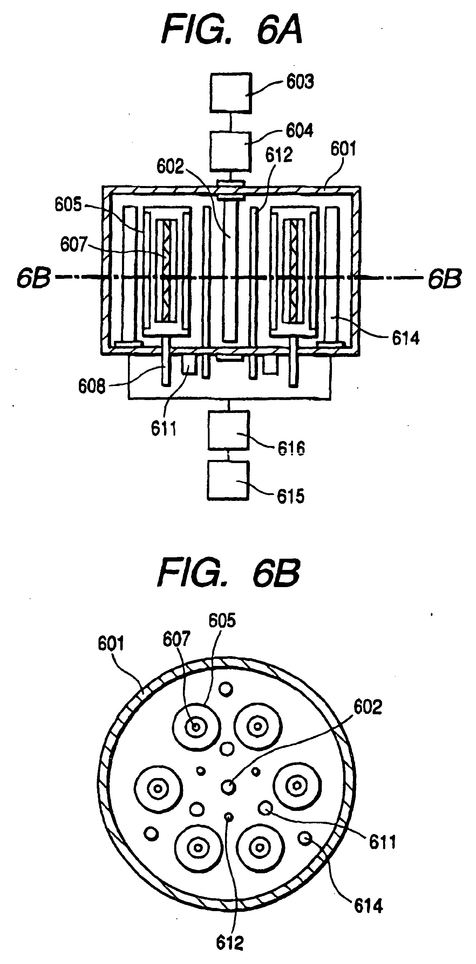

FIGS. 6A and 6B are schematic diagrams of a plasma processing apparatus capable of supplying a plurality of high frequency powers of different frequencies to the reactor container at the same time as described above. FIG. 6A is a longitudinal sectional view of the plasma processing apparatus, and FIG. 6B is a transverse sectional view taken along the 6B-6B line in FIG. 6A.

An exhaust pipe 611 is provided in the lower part of a reactor container 601 included in this plasma processing apparatus, and the other end of this exhaust pipe 611 is connected to an exhausting system (not shown). In this reactor container 601, six cylindrical substrates 605 on which a deposition film is to be formed are placed in parallel to one another in such a manner as to surround the central portion. Each cylindrical substrate 605 is supported on a rotation shaft 608, and is heated by a heating element 607. When a motor (not shown) is driven, the rotation shaft 608 is rotated via a gear (not shown), and the cylindrical substrates 605 are thereby rotated around the central axis in the generatrix line direction thereof (central axis along the lengthwise direction of the cylindrical substrate).

A raw material gas is supplied from a raw material gas supply pipe 612 to a reactor container 601. A high frequency power is supplied from a first high frequency power supply 603 through a first matching box 604 and then an internal high frequency electrode 602 to the reactor container 601, and is also supplied from a second high frequency power supply 615 through a second matching box 616 and then an external high frequency electrode 614 to the reactor container 601.

The method of forming a deposition film using this plasma processing apparatus is generally carried out according to the procedure described below.

First, the cylindrical substrates 605 are installed in the reactor container 601, and gas in the reactor container 601 is exhausted by the exhausting system (not shown) via the exhaust pipe 611. Subsequently, the cylindrical substrates 605 are heated by a heating element 607 while control is performed so that they are kept at a predetermined temperature of about 200 to 300°C.

When the cylindrical substrates 605 are heated to a predetermined temperature, the raw material gas is introduced into the reactor container 601 via the raw material gas supply pipe 612. After the flow rate of the raw material gas reaches a preset rate, and the pressure in the reactor container 601 is stabilized, the output of the first high frequency power supply 603 is set at a predetermined value, and at the same time, the output of the second high frequency power supply 615 is set at a predetermined value. Subsequently, the impedance of the matching circuit in the first matching box 604 is adjusted so that the output impedance of the first high frequency power supply 603 equals the impedance at the inlet of the first matching box 604. At the same time, the impedance of the matching circuit in the second matching box 616 is adjusted so that the output impedance of the second high frequency power supply 615 equals the impedance at the inlet of the second matching box 616.

In this way, the high frequency power is efficiently supplied to the reactor container 601 via the internal high frequency electrode 602 and the external high frequency electrode 614, and thus a glow discharge is produced in the reactor container 601, whereby the raw material gas is excited and dissociated to form a deposition film on the cylindrical substrate 605.

After a deposition film having a desired thickness is formed, the supply of high frequency power is stopped, and subsequently the supply of the raw material gas is stopped to complete the forming of the deposition film. By repeating the same operation several times, a desired multilayered light-receiving layer of multi-layer structure can be formed.

During formation of the deposition film, the cylindrical substrate 605 is rotated at a predetermined speed with the motor via the rotation shaft 608 to uniformly form the deposition film over the entire surface of the cylindrical substrate 605.

The above-described methods and apparatus can realize good deposition film formation. However, the level of demands in the market on products produced using such plasma processing are being raised day by day, and for satisfying the demands, there is a need for a plasma processing method and apparatus to produce a product with higher quality.

For example, for the electrophotographic photosensitive member, an enhanced copy speed, enhanced image quality and a reduced price are quite highly demanded, and in order to realize these, enhancement of photosensitive member characteristics, specifically, electrification capability, sensitivity or the like, and reduction in costs for producing photosensitive members have become essential. Besides, with digital electrophotographic apparatus or color electrophotographic apparatus, which have remarkably become widespread recently, copies of photographs, pictures, design drawings or the like, as well as scripts are frequently made, and it is therefore required more strongly to reduce optical memory of the photosensitive member and to reduce unevenness of image density.

For achieving the improvement of plasma processing characteristics and reduction in costs for plasma processing, a technique enabling the plasma having desired properties to be produced and maintained with stability and good reproducibility has become important. For example, for plasma processing using a conventional plasma processing apparatus shown in FIGS. 4A and 4B, the impedance in the matching box is generally adjusted automatically in terms of labor saving. In the conventional method of adjusting the impedance as described above, however, proper control is not necessarily performed, for example, if the load impedance is temporarily changed due to abnormal discharge such as sparks.

Because the abnormal discharge itself is transient in most cases, and it often occurs in such a place that materials to be treated are not adversely influenced, so that the plasma processing may be prevented from being adversely influenced directly by the abnormal discharge. In the conventional method of adjusting the impedance, however, there are cases where when abnormal discharge occurs, the impedance of the matching box is adjusted so as to obtain matching with the load impedance in the abnormal state, and consequently an impedance considerably deviated from a normal matching condition is set. As a result, the normal impedance cannot be recovered immediately after the abnormal discharge is eliminated, which may lower plasma processing characteristics themselves and impair the stability of plasma processing characteristics. There are also cases where the impedance of the matching box is considerably changed when the abnormal discharge occurs, and thereby the abnormal discharge is further developed, thus making it impossible to recover the normal plasma condition. In this way, in the conventional method of adjusting the impedance, an adequate measure to counter a sudden change in load impedance caused by an abnormal discharge or the like is not necessarily provided.

For the technique aiming at the adjustment of impedance, for example, Japanese Patent Application Laid-Open No. 09-260096 discloses a technique for automatically searching a matching point of impedance in which a matching point of an impedance with which plasma is ignited is searched using a preset impedance as a reference to ignite the plasma, and then a matching point of the preset impedance used as a reference for providing stable plasma discharge is automatically reached, followed by stabilizing the plasma discharge using the matching point as a reference, wherein plasma can reliably be ignited even if the load impedance is varied with plasma processing.

According to this technique, troubles during production of plasma, for example, problems such that plasma is unignited for a long time and so on are solved, but the above-described problems occurring after a discharge is brought about, for example, problems in the case where an abnormal discharge occurs have not been solved yet.

Also, Japanese Patent Application Laid-Open No. 11-087097 (corresponding to U.S. Patent No. 5,936,481) discloses a technique directed to matching of impedance and power control systems, in which the impedance of each element in the matching circuit is fixed at a predetermined value for the matching of impedance, and the adjustment of impedance is carried out with the frequency of high frequency power being changed. According to this technique, because the adjustment of impedance can be performed with an electrical process such that the frequency of high frequency power is changed, the impedance is quickly adjusted. In the case of this technique, however, according to the study made by the inventors, if an abnormal discharge occurs during plasma processing, and the load impedance is abruptly changed, matching is immediately provided in correspondence to the impedance, and thus the abnormal discharge may be promoted. Also, in the case of this matching of impedance with the frequency of high frequency power being changed, the frequency is varied for each process lot, and as a result there may be variations between plasma processing characteristics. These variations are significant especially when the frequency of high frequency power is sensitive to the uniformity of plasma processing characteristics as in the frequency of high frequency power that is in the VHF band.

Japanese Patent Application Laid-Open No. 08-096992 discloses a technique in which the impedance is adjusted in the early stage of each step in plasma processing, no impedance adjustment is thereafter carried out in the step, and the impedance adjustment is started again in the next step, followed by maintaining the same conditions, wherein specific timing for adjustment of impedance includes (1) a short time period for adjustment in the early stage of each step and (2) the time that reflection is abnormally increased. This technique reportedly eliminates the inappropriate adjustment of impedance occurring when the high frequency power is supplied from a plurality of electrodes, thus making it possible to prevent the plasma from being destabilized. When this technique is used, no impedance adjustment is carried out even if the abnormal discharge occurs, and the abnormal discharge is prevented from being promoted. In the case of this technique, however, a change in impedance over time during plasma processing is not dealt with, and mismatching of impedance is caused by, for example, a change in load impedance during the early stage of plasma processing, or a difference between the impedance in the early stage of processing and the impedance immediately before the processing is ended in long plasma processing.

Consequently, there are cases where adequate plasma processing properties cannot be obtained due to this mismatching. Also, since the level of the mismatching varies depending on the condition of the reactor container, the plasma processing characteristic may be different for each plasma processing lot.

In addition, in the plasma processing method in which a plurality of high frequency powers, especially a plurality of high frequency powers of different frequencies are supplied to the reactor container at the same time, significant effects can be obtained, but control of plasma is difficult, and in present situation, there is a need for a variety of improvements in producing plasma having desired characteristics with stability and good reproducibility.

When a plurality of high frequency powers are supplied to the reactor container at the same time, and particularly the plurality of high frequency powers have different frequencies, the high frequency powers interfere with one another. Therefore, in the conventional method of adjusting the impedance as described above, there are cases where accurate adjustment of impedance cannot be carried out due to interference of the plurality of high frequency powers.

For example, in the case where the first high frequency power and the second high frequency power are supplied to the reactor container at the same time, the first high frequency power propagates through the reactor container into the power supply system for the second high frequency power. As a result, it appears as if the first high frequency power that should not exist originally were existing as a reflected wave in the power supply system for the second high frequency power, and thus there may arise a phenomenon in which the outputs of a power meter, a phase detector and an impedance detector do not reflect accurately matching conditions. Also, a similar phenomenon may occur in the power supply system for the first high frequency power, thus making it impossible to correctly keep track of matching conditions.

In this situation, the level of influence varies depending on the conditions of the power outputted from the other power supply system, namely the value of power, its phase and the like. Therefore, although the condition of one power supply system is kept constant, for example, it appears as if load conditions changed when the condition of the other power supply system is changed, namely, the impedance of the matching device is changed, so that inappropriate impedance adjustment would be carried out in spite of the fact that there is no change in matching conditions. As a result, in some cases, impedance considerably deviated from a real matching point is provided, causing the plasma to be destabilized.

As a measure to counter these problems, a high pass filter and a low pass filter are generally installed in each power supply system. However, in this measure using filters, some degree of effect can be obtained, but it is difficult to completely inhibit the diffraction of power, and some influence by interference often remains. Particularly, when a plurality of powers of relatively close frequencies is used, it is generally quite difficult to adequately inhibit the diffraction of the other high frequency power even if filters are installed.

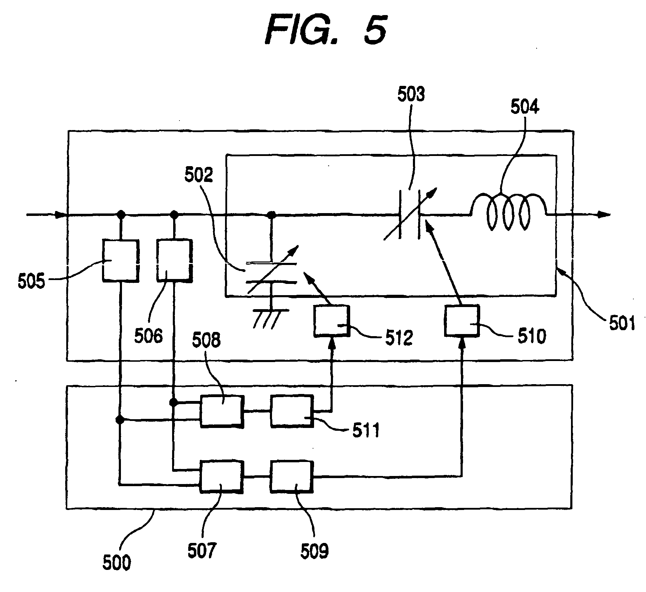

For example, when using the plasma processing apparatus shown in FIGS. 6A and 6B, a control system having such a configuration as shown in FIG. 5 is used as the control system provided in the matching boxes 604 and 616 to carry out vacuum processing, the following phenomenon may occur.

For producing plasma in the reactor container 601, the raw material gas is introduced into the reactor container 601 via the raw material gas supply pipe 612, and thereafter the outputs of the first high frequency power 603 and the second high frequency power 615 are set at predetermined values, respectively, followed by adjusting the impedances of the matching circuits in the first matching box 604 and the second matching box 616. Specifically, in the first matching box 604 and the second matching box 616, the phase of impedance at the inlet of the matching circuit 501 is detected by the phase difference detector 507, and then a voltage consistent with the phase of impedance is outputted to the tuning control circuit 509.

The tuning control circuit 509 compares the voltage inputted from the phase difference detector 507 with a reference voltage, and then supplies a voltage consistent with the difference therebetween to the motor 510 for driving the tuning variable condenser 503. The tuning variable condenser 503 is adjusted by the motor 510 so that the phase of impedance consequently equals a predetermined value, generally "0." At the same time, the impedance detector 508 detects an absolute value of impedance at the inlet of the matching circuit 501, and then outputs a voltage consistent with the absolute value of impedance to the matching control circuit 511. The matching control circuit 511 compares the voltage inputted from the impedance detector 508 with the reference voltage, and then supplies a voltage consistent with the difference therebetween to the motor 512 for driving the matching variable condenser 502. The matching variable condenser 502 is adjusted by the motor 512 so that the absolute value of impedance consequently equals a predetermined value, generally 50 $\Omega$.

In the actual adjustment of impedance, however, when the tuning variable condenser 503 and the matching variable condenser 502 of the first matching box 604 are changed, for example, the phase of impedance and the absolute value of impedance detected in the second matching box 616 are changed. Therefore, the tuning variable condenser 503 and the matching variable condenser 502 of the second matching box 616 are changed, but on the other hand the phase of impedance and the absolute value of impedance detected in the first matching box 604 are also changed. With such a situation being repeated, the impedance of each matching box may be subjected to constant fluctuations. If this situation is brought about, the produced plasma is not stabilized, and in some cases, plasma processing characteristics are adversely affected significantly.

As another method of adjusting the impedance, the power reflectivity, namely the value of reflected power/ incident power, at the inlet of the matching box is used. In this adjustment method, for example, the capacity of the tuning variable condenser is changed to increase or decrease the same, and the capacity of the tuning variable condenser is further changed in the same way if the power reflectivity consequently drops, or the capacity of the tuning variable condenser is changed in the opposite way if the power reflectivity consequently increases. The matching variable condenser is also controlled in the same manner as described above to adjust the capacity of each variable condenser to the impedance condition under which the minimum power reflection power ratio is achieved.

This adjustment method may cause the following problems. For example, assume that the capacity of the tuning variable condenser is smaller than the matching impedance in the first matching box 604. In this situation, if the capacity of the tuning variable condenser is changed so that it decreases, the power reflectivity is essentially increased in accordance therewith, and upon reception of a signal indicating that the power reflectivity is increased, the motor should be rotated inversely to change the capacity of the condenser in a reverse way so that it increases. In the case where the capacity of the tuning variable condenser or the matching variable condenser is changed in the second matching box 616 at the same time, however, the power reflectivity in the first matching box 604 may be erroneously considered to have dropped in association with this change. This is due to the fact that the power supply system for the first high frequency power is coupled to the power supply system for the second high frequency power via the plasma. That is, when observing the load from the power supply system for the first high frequency power, the load is such that the plasma is combined with the output impedance of the power supply system of the second high frequency power. Therefore, when the capacities of the tuning variable condenser and the matching variable condenser in the second matching box 616 are changed, it appears as if the load impedance was changed if observing from the power supply system of the first high frequency power.

Therefore, in the first matching box 604, the capacity of the tuning variable condenser is changed so that it further decreases, resulting in the capacity being still further deviated with respect to the matching impedance. Such a phenomenon similarly occurs in adjustment of the capacity of the matching variable condenser, and may also occur in the tuning variable condenser and the matching variable condenser of the second matching box 616. Therefore, in the first matching box 604 and the second matching box 616, no matching point cannot be found for a long time, and in some cases, the impedances of the first matching box 604 and the second matching box 616 may take on values so largely deviated with respect to the matching impedance that the plasma can no longer be maintained, resulting in discharge break.

The phenomenon described above can occur more easily when the high frequency powers for a plurality of power supply systems have different frequencies, and particularly in the VHF frequency band.

In this way, there is a problem such that the variation in plasma processing characteristics due to inappropriately conducted impedance adjustment is one of important factors in achieving the improvement of plasma processing characteristics and the reduction in costs for plasma processing. That is, the improvement of impedance adjustment technique has been a challenge in achieving the improvement of plasma processing characteristics and the reduction in costs for plasma processing.

Although a variety of devices have been made hitherto for impedance adjustment, in this way, an adjustment method capable of appropriately dealing with a sudden change in load impedance caused by abnormal discharge or the like during plasma processing has not been proposed.

## SUMMARY OF THE INVENTION

The object of the present invention is to solve the above problems. Specifically, an object of the invention is to provide a plasma processing method and a plasma processing apparatus for plasma processing an object to be processed, which is placed in a reactor container, by decomposing a raw material gas introduced into the reactor container by introducing a high frequency power outputted from a high frequency power supply into the reactor container via a matching device and an electrode, wherein the impedance adjustment by the matching device is achieved properly and stably, thus making it possible to achieve the improvement of plasma processing characteristics, the improvement of reproducibility of plasma processing characteristics and the reduction in costs for plasma processing.

As a result of vigorously conducting studies for achieving the above object, the inventors have found that in the adjustment of impedance by the matching device, changing the impedance of each variable circuit element in the matching circuit only within a predetermined range (hereinafter often referred to as "predetermined impedance variable range"), adjusting the impedance so that a preset matching goal condition is satisfied, and changing the impedance variable range as the plasma processing proceeds are effective in achieving the above object.

The present invention provides a plasma processing method comprising introducing a high frequency power outputted from a high frequency power supply into a reactor container via a matching device and an electrode, decomposing a raw material gas introduced into the reactor container by means of the high frequency power and processing an object to be processed which is placed in the reactor container, wherein the adjustment of impedance by the matching device during plasma processing is controlled within a predetermined impedance variable range, and the impedance variable range is changed as the plasma processing proceeds.

Another object of the present invention is to provide a plasma processing method comprising introducing high frequency powers into a reactor container via electrodes from a plurality of power supply systems having high frequency power supplies and matching devices capable of changing impedances, decomposing a raw material gas introduced into the reactor container by means of the high frequency powers, and plasma processing a substrate to be processed which is placed in the reactor container, wherein the adjustment of impedance by at least one matching device of the matching devices of the plurality of power supply system during plasma processing is automatically controlled within a predetermined impedance variable range.

Another object of the present invention is to provide a plasma processing apparatus comprising a reactor container for plasma processing a substrate to be processed, raw material gas supplying means for supplying a raw material gas to the reactor container, and a plurality of power supply systems for supplying high frequency powers to the reactor container, wherein the plurality of power supply systems have matching circuits capable of changing impedances and control systems for controlling the impedances of the matching circuits, the control system being capable of storing a variable range setting value for limiting an impedance variable range.

## BRIEF DESCRIPTION OF THE DRAWINGS

FIG. 1 shows an outline of a configuration in a matching device (matching box) capable of being used in the plasma processing method of the present invention;

FIGS. 2A and 2B are schematic diagrams showing an example of an apparatus (plasma processing apparatus) for producing light-receiving members for electrophotography based on a VHF plasma CVD method using the VHF band;

FIG. 3 is a schematic diagram showing an example of the apparatus (plasma processing apparatus) for producing light-receiving members for electrophotography based on the plasma CVD method using the RF band;

FIGS. 4A and 4B are schematic diagrams showing an example of the apparatus (plasma processing apparatus) for producing light-receiving members for electrophotography based on the VHF plasma CVD method using the VHF band;

FIG. 5 shows an outline of an example of the configuration in the matching device (matching box) used in a conventional plasma processing apparatus;

FIG. 6A is a longitudinal sectional view showing another conventional plasma processing apparatus;

FIG. 6B is a transverse sectional view taken along the 6B-6B line of FIG. 6A, which shows the plasma processing apparatus;

FIG. 7A is a longitudinal sectional view showing a plasma processing apparatus according to the present invention; and

FIG. 7B is a transverse sectional view taken along the 7B-7B line of FIG. 7A, which shows the plasma processing apparatus.

## DESCRIPTION OF THE PREFERRED EMBODIMENTS

According to the present invention, the adjustment of impedance by a matching device is carried out properly and stably, thus making it possible to achieve the improvement of plasma processing characteristics, the improvement of reproducibility of plasma processing characteristics and the reduction in costs for plasma processing.

The present invention will be described in detail below.

According to the present invention, since the adjustment of impedance by the matching device is carried out within a predetermined impedance variable range, the adjustment of impedance of the matching circuit is carried out only within the impedance variable range even if the load impedance is significantly changed due to abnormal discharge or the like, and therefore there is no significant deviation from the normal impedance, thus making it possible to prevent problems such that the abnormal discharge is promoted, and that it takes much time for the impedance to return to a proper value after the abnormal discharge occurs. In addition, the present invention is characterized in that this impedance variable range is changed as the plasma processing proceeds. This is to deal with the situation in which conditions in the reactor container, for example conditions of wall surfaces in the early stage of plasma processing differ from those after the plasma processing somewhat proceeds, and consequently the load impedance is changed as the plasma processing proceeds. When the adjustment of impedance is carried out within the same impedance variable range throughout plasma processing, the impedance variable range should be set to be wide for dealing with the situation in which the load impedance is changed as the plasma processing proceeds. As a result, the adjustment of impedance may not be achieved properly and stably. Therefore, the present invention is characterized in that the adjustment of impedance by the matching device is carried out within a predetermined impedance variable range, and the impedance variable range is changed as the plasma processing proceeds, and this feature allows the stability of plasma to be further improved, thus making it possible to achieve the improvement of plasma processing characteristics, the improvement of reproducibility of plasma processing characteristics and the reduction in costs for plasma processing.

In the present invention described above, it is more effective to substantially continuously change the impedance variable range as the plasma processing proceeds. In the case where the impedance variable range is changed discontinuously, the impedance of the matching circuit may also be changed substantially discontinuously as the impedance variable range is changed if the impedance of the matching circuit before being changed is close to the demarcation of the variable range, and as a result, discontinuous matching may occur, thus making it impossible to draw the best effect from the present invention. This situation tends to rise in plasma processing in which a plurality of processes with different conditions is carried out continuously. Therefore, it is more effective to substantially continuously change the impedance variable range especially when the conditions are steeply changed among a plurality of processes.

In the present invention, it is further more effective to preset conditions as criteria for determining that matching has been obtained to stop the adjustment of impedance, namely matching goal conditions, and change as necessary the matching goal conditions as the plasma processing proceeds. The matching goal conditions are generally set with the absolute value of impedance at the inlet of the matching circuit, the phase of impedance, the power reflectivity and combinations thereof, and when the detected value is within the preset range, it is determined that matching has been obtained to stop the adjustment of impedance of the matching circuit. If the preset range is too narrow, however, the detected value at the time of plasma processing cannot be adjusted so as to be within the preset range, and the impedance of the matching circuit is continuously adjusted, thus making it difficult to maintain stable plasma in some cases. On the other hand, if the preset range is too wide, there may be cases where the adjustment of impedance is stopped in spite of the fact that matching is not sufficiently achieved, resulting in the situation in which efficiency of power supply drops, and desired plasma characteristics cannot be obtained. In addition, there may be cases where variations of impedance among plasma processing lots are increased, and thus reproducibility of plasma processing characteristics is insufficiently achieved.

Therefore, setting the matching goal conditions to proper values is also important in producing plasma of desired characteristics with stability and good reproducibility. In actual plasma processing, proper matching goal conditions are also changed as the plasma processing proceeds since conditions in the reactor container change as the plasma processing proceeds, as described above. Conventionally, even when proper matching goal conditions are changed as the plasma processing proceeds as described above, matching goal conditions are not changed to the proper conditions, and matching goal conditions are set to be wider so that all the proper matching goal conditions throughout plasma processing are included, which sometimes presets obstacles to the improvement of reproducibility of plasma processing properties. Thus, the matching goal conditions are changed as necessary as the plasma processing proceeds, whereby such obstacles can be eliminated to achieve further improvements of reproducibility of plasma processing characteristics.

It is more effective to substantially continuously change the matching goal conditions as the plasma processing proceeds as in the case of changing the impedance variable range. In the case where the matching goal conditions are changed discontinuously, the matching conditions may also be changed discontinuously as the matching goal conditions are changed if the matching conditions before being changed are close to the demarcation of the matching goal conditions, and as a result, thus making it impossible to draw the best effect from the present invention. This situation tends to rise in plasma processing in which a plurality of processes with different conditions is carried out continuously. Therefore, it is more effective to substantially continuously change the matching goal conditions especially when the conditions are steeply changed among a plurality of processes.

Also, in the present invention, automatic control of the adjustment of impedance may be performed before and after the starting of plasma processing or may be performed only after the starting of plasma processing. In the case where the automatic control is performed before and after the starting of plasma processing, the impedance variable range for the matching circuit is preferably changed before and after the plasma is produced because the load impedance may significantly be changed before and after the plasma is produced. On the other hand, in the case where the automatic control is started after the starting of plasma processing, the impedance may be adjusted manually to produce the plasma, or the plasma may be produced by determining the impedance of each element in the matching circuit suitable for production of plasma, presetting the impedance of each element in the matching circuit to the determined value before producing the plasma, and then gradually increasing the output of the high frequency power supply. In this case, the most suitable impedance of each element in the matching circuit during production of plasma somewhat varies depending on conditions in the reactor container among plasma processing lots, but substantially detrimental effects are prevented by immediately starting the automatic control after the plasma is produced. Furthermore, the plasma production may be detected with a method that has been well known, such as detection using visual observation and a photoreceptor, detection using fluctuation of pressure in the reactor container, and detection using a change in load impedance.

The present invention described above can produce remarkable effects when the frequency of high frequency power used in plasma processing is not lower than 50 MHz and not higher 250 MHz. This is presumably because plasma tends to suffer unevenness in this frequency band, and if the adjustment of impedance of the matching circuit is inappropriately carried out, the evenness of plasma is easily affected adversely. Also, if an abnormal discharge occurs, the abnormal discharge is easily promoted in this frequency band as long as the impedance of the matching circuit is inappropriate, and therefore the promotion of such abnormal discharge can effectively be curbed to obtain remarkable effects of the present invention by applying the present invention in plasma processing using a high frequency power having a frequency not lower than 50 MHz and not higher than 250 MHz, although its mechanism is not elucidated at the present time.

The present invention described above can produce remarkable effects particularly when the object to be processed moves or rotates at least temporarily during plasma processing. In the case where the object to be processed moves or rotates during plasma processing, the load impedance is often changed in association therewith. When a cylindrical substrate is rotated while it is subjected to plasma processing, for example, the relative position of the substrate in the reactor container is often slightly changed due to the eccentricity during rotation. In this way, an abnormal discharge tends to occur when the relative position of the substrate is changed, and the load impedance is changed in association with the change of position. In the present invention, even if such abnormal discharge occurs, the impedance of the matching circuit is limited to around a proper value, and therefore problems such that the impedance of the matching circuit is significantly deviated from the proper value, and the abnormal discharge is promoted, are prevented, thus making it possible to maintain stable plasma.

Also, the present invention can produce significant effects particularly when plasma processing is conducted for forming an electrophotographic photosensitive member. This is presumably because of the following two factors. First, when the electrophotographic photosensitive member is formed, a deposition film with thickness of several tens $\mu$m is generally formed, and thus much time is required for plasma processing. Therefore, a sudden change in load impedance often occurs due to an abnormal discharge or the like during plasma processing, and the present invention may produce remarkable effects to curb a harmful influence on plasma processing in association with this change. In addition, because it takes much time to conduct plasma processing, the load impedance is significantly changed with time during plasma processing, and the effect of the present invention to properly adjust the impedance with respect to this change with time may be remarkable particularly when the electrophotographic photosensitive member is formed. Second, in formation of the electrophotographic photosensitive member, a plurality processes of plasma processing with different conditions such as gas species, pressure and high frequency powers are carried out continuously. Furthermore, the term "continuously" refers to not just a situation in which plasma processing conditions are continuously changed while keeping the state of produced plasma, but a situation in which the discharge is stopped on a temporary basis at the time of changing processing conditions, and thereafter the processing conditions are changed to produce the plasma again. It has been found that in the case where a plurality of processes of plasma processing with different conditions are carried out continuously, the proper impedance variable range or the proper matching goal condition is different for each condition, and thus the impedance may be properly adjusted throughout a series of plasma processing, resulting in satisfactory plasma processing being performed by using the present invention to set a proper impedance variable range or proper matching goal condition for each condition.

The present invention is a plasma processing method for plasma processing a substrate to be processed, which is placed in a reactor container, by decomposing a raw material gas introduced into the reactor container by introducing high frequency powers into the reactor container via electrodes from a plurality of power supply systems having high frequency power supplies and matching devices. In the plasma processing method according to the present invention, the adjustment of impedance by at least one matching device, of the matching devices provided in the plurality of power supply systems, is carried out with automatic control within a predetermined impedance variable range.

Also, the plasma processing apparatus according to the present invention comprises a reactor container for plasma processing a substrate to be processed, raw material gas supplying means for supplying a raw material gas to this reactor container, and a plurality of power supply systems for supplying high frequency powers to the reactor container. Also, in the plasma processing apparatus according to the present invention, a plurality of power supply systems have matching circuits capable of changing impedances, and control systems for controlling impedances of the matching circuits. The control system can store variable range setting values for limiting impedance variable ranges.

According to the plasma processing method and the plasma processing apparatus having configurations described above, the adjustment of impedance by the matching device is carried out for each variable circuit element of the matching circuit within a predetermined impedance variable range. According to this plasma processing method, the matching of impedance is carried out only within the predetermined impedance variable range, and therefore the impedance of the matching circuit is prevented from being significantly deviated from the proper value even when a plurality of high frequency powers are introduced into the reactor container at the same time.

According to this plasma processing method, the impedance of each matching circuit is prevented from being significantly deviated from the proper value, and therefore the variation of apparent load impedance in one matching circuit due to the change of impedance of the other matching circuit are limited to within some level of variation, thus making it possible to achieve stabilization of plasma. Also, the impedance of the matching circuit is not fixed at a predetermined value, thus making it possible to keep track of a change in the load impedance associated with a change in conditions in the reactor container occurring as plasma processing proceeds.

Also, in the present invention, effects of stabilizing plasma can be obtained by carrying out this adjustment of impedance in at least one of a plurality of high frequency power supply systems, but this adjustment of impedance is preferably carried out in all high frequency power supply systems for obtaining remarkable effects.

Also, the present invention is particularly effective when a plurality of high frequency powers of different frequencies are supplied to the reactor container at the same time, and is thus preferable. That is, in the case where a plurality of high frequency powers of different frequencies are supplied to the reactor container at the same time, interference between the power supply systems easily arises as described above, and stabilization of plasma becomes further difficult in the conventional method of adjusting the impedance, while the present invention can produce adequate effects of stabilizing the plasma even in this case.

Also, the plasma processing method according to the present invention can produce further more remarkable effects when a plurality of high frequency powers are supplied to the reactor container from the same high frequency electrode at the same time, and is thus preferable. In the case where a plurality of high frequency powers are supplied to the reactor container from the same high frequency electrode at the same time, the power supply systems are electrically coupled to one another directly through the high frequency electrode and therefore interference more easily arises, and stabilization of plasma becomes further difficult in the conventional method of adjusting the impedance, while the present invention can produce adequate effects of stabilizing the plasma even in this case.

Also, in the plasma processing method according to the present invention, preferably two types of high frequency powers having frequencies not lower than 10 MHz and not higher than 250 MHz are supplied, respectively, when a plurality of different high frequency powers are supplied to the reactor container at the same time, and provided that the frequency of the high frequency power having a higher frequency is represented by $f_1$ and the frequency of the high frequency power having a lower frequency is represented by $f_2$, preferably the condition of $0.1 \leq f_2/f_1 \leq 0.9$, more preferably the condition of $0.5 < f_2/f_1 \leq 0.9$ is satisfied. In these conditions, the interference described above easily arises in general, and thus the discharge instability is significantly increased, but by applying the present invention, the influence of this interference can remarkably be inhibited, and as a result, a stable discharge can be maintained.

For specific embodiments of the present invention, the plasma processing apparatus and the method of forming a deposition film will be described below with reference to the drawings.

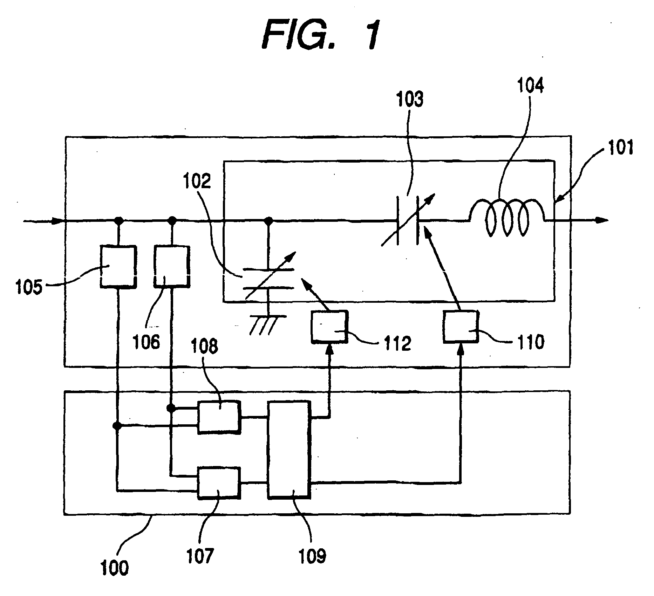

FIG. 1 shows an outline of a configuration in a matching device (matching box) capable of being used in the present invention. The matching device is constituted by a system including a matching circuit 101 and a control system 100. The matching circuit 101 is constituted by a matching variable condenser 102, a tuning variable condenser 103 and a coil 104, and at the inlet of the matching circuit 101, a high frequency current is detected by a current detection element 105 and a high frequency voltage is detected by a voltage detection element 106. The outputs of the current detection element 105 and the voltage detection element 106 are inputted to a phase difference detector 107 and an impedance detector 108 in the control system 100. In the phase difference detector 107, the phase of impedance at the inlet of the matching circuit 101 is detected, and a voltage consistent with the phase of impedance is outputted to an impedance/phase control unit 109. In the impedance/phase control unit 109, the impedance of the tuning variable condenser 103 is controlled within a predetermined variable range based on the voltage inputted from the phase difference detector 107. Specifically, the voltage inputted from the phase difference detector 107 is compared with a reference voltage, and a voltage consistent with the difference therebetween is supplied to a motor 110 for driving the tuning variable condenser 103. In this case, when the impedance of the tuning variable condenser 103 reaches the maximum or minimum value in the predetermined variable range, the impedance/phase control unit 109 immediately stops supplying the voltage to the motor 110. Also, if the impedance of the tuning variable condenser 103 has already reached the maximum value in the predetermined variable range, the impedance/phase control unit 109 conducts the supply of voltage to the motor 110 for decreasing the impedance of the tuning variable condenser 103, but does not conduct the supply of voltage for increasing the impedance of the tuning variable condenser 103. Similarly, if the impedance of the tuning variable condenser 103 has already reached the minimum value in the predetermined variable range, the impedance/phase control unit 109 conducts the supply of voltage to the motor 110 for increasing the impedance of the tuning variable condenser 103, but does not conduct the supply of voltage for decreasing the impedance of the tuning variable condenser 103. In this way, the impedance of the tuning variable condenser 103 is controlled within a predetermined variable range so that the phase of impedance at the inlet of the matching circuit 101 may be within the predetermined range, and if matching goal conditions are not satisfied within the predetermined range, the adjustment of impedance of the tuning variable condenser 103 is stopped with the phase being closest to the matching goal condition.

On the other hand, in the impedance detector 108, the absolute value of impedance at the inlet of the matching circuit 101 is detected, and a voltage consistent with the absolute value of impedance is outputted to the impedance/phase control unit 109. In the impedance/phase control unit 109, the voltage inputted from the impedance detector 108 is compared with a reference voltage, and a voltage consistent with the difference therebetween is supplied to a motor 112 for driving the matching variable condenser 102. In this case, the impedance/phase control unit 109 stops supplying the voltage to the motor 112 at the time when the impedance of the matching variable condenser 102 reaches the maximum or minimum value in the predetermined variable range. Also, if the impedance of the matching variable condenser 102 has already reached the maximum value in the predetermined variable range, the impedance/phase control unit 109 conducts the supply of voltage to the motor 112 for decreasing the impedance of the matching variable condenser 102, but does not conduct the supply of voltage for increasing the impedance of the matching variable condenser 102. Similarly, if the impedance of the matching variable condenser 102 has already reached the minimum value in the predetermined variable range, the impedance/phase control unit 109 conducts the supply of voltage to the motor 112 for increasing the impedance of the matching variable condenser 102, but does not conduct the supply of voltage for decreasing the impedance of the matching variable condenser 102. In this way, the impedance of the matching variable condenser 102 is controlled within a predetermined variable range so that the absolute value of impedance at the inlet of the matching circuit 101 may be within the predetermined range, and if matching goal conditions are not satisfied within the predetermined range, the adjustment of impedance of the matching variable condenser 102 is stopped with the impedance being closest to the matching goal condition.

By this control, the adjustment of impedance is carried out with automatic control in a predetermined impedance variable range. Furthermore, for the method of detecting the impedances of the tuning variable condenser 103 and the matching variable condenser 102, a method that has been well known may be used, such as a method in which the shift amounts of a variable condenser and a mechanical unit for driving the condenser are detected, and a method in which a stepping motor is used as a motor for driving the variable condenser to detect the impedance based on its drive signal. Also, the impedances of the tuning variable condenser 103 and the matching variable condenser 102 do not necessarily need to be always detected, but instead the signal may be outputted to the impedance/phase control unit 109 at the time when the impedances of the tuning variable condenser 103 and the matching variable condenser 102 reach maximum or minimum value in the variable range.

Furthermore, the term "impedance variable range" in the present invention does not refer to an impedance variable range limited in terms of configuration by the variable width of impedance variable elements constituting the matching circuit, but an impedance variable range determined independently thereof.

By determining an impedance variable range independently of the variable width of impedance variable elements in this way, the impedance variable range can be set to a desired range with high accuracy, and the set range can be changed easily. As a result, discharge stability during vacuum processing can be improved, and the determined impedance variable range can be changed during vacuum processing, thus making it possible to accommodate even a plurality processes being carried out continuously.

The plasma processing using a matching box having a configuration shown in FIG. 1 can be conducted according to the following procedure when an electrophotographic photosensitive member constituted by a charge injection blocking layer, a photoconductive layer and a surface layer is formed, using a plasma processing apparatus as shown in FIGS. 4A and 4B.

First, prior to formation of the electrophotographic photosensitive member, the impedance of the matching variable condenser 102 and the impedance of the tuning variable condenser 103 at which plasma is maintained with stability are determined through a preliminary experiment in advance including variations among lots, for conditions of each of the charge injection blocking layer, photoconductive layer and surface layer, and the impedance variable range of the matching variable condenser 102 and the impedance variable range of the matching variable condenser 103 of each layer are determined based on the result of the preliminary experiment. The impedance variable range is determined as appropriate in accordance with plasma formation conditions, the configuration of apparatus to be used, and the like, in such a manner that just the range of variations, or fluctuations of the impedance of the matching variable condenser 102 and the impedance of the tuning variable condenser 103 obtained from the preliminary experiment is defined as the variable range, or a range approximately twice as wide as the range of variations of impedance is defined as the impedance variable range, for example, so that plasma can be maintained with stability in actual plasma processing.

According to considerations by the inventors, it is preferable that the impedance variable range is set within a range approximately twice as wide as the range of variations of impedance obtained from the preliminary experiment in maintaining stable plasma. If the impedance of the variable condenser varies between 200 pF and 300 pF according to the preliminary experiment, namely the width of variations of impedance is 100 pF, for example, the impedance variable range of the variable condenser is preferably set to a range twice as wide as the range of variations, namely the width of 200 pF, and in the case of this example, the impedance variable range of the variable condenser is preferably set within the range of from 150 pF to 350 pF.

The impedance variable range of the matching variable condenser 102 and the impedance variable range of the tuning variable condenser 103 of each of the charge injection blocking layer, photoconductive layer and surface layer determined in this way are stored in the impedance/phase control unit 109 in advance, and the impedance variable range of the matching variable condenser 102 and the impedance variable range of the matching condenser 103 may be changed in accordance with the timing of switching of layers, or data may be sent from the outside to the impedance/phase control unit 109 in accordance with the timing of switching of layers, or the impedance Variable range may be changed by other methods.

Also, the number of impedance variable ranges for each layer is not necessarily one, but instead two or more impedance variable layers may be set for each layer. In this case, the impedance variable range is switched to the next impedance variable range at a predetermined midpoint of the layer. Conversely, different impedance variable ranges are not necessarily set for different layers, but instead, for example, the same impedance variable range may be used for the charge injection blocking layer and the photoconductive layer, or the same impedance variable range may be used for the photoconductive layer and the surface layer, or the same impedance variable range may be used for the blocking layer and the initial portion of the photoconductive layer and the impedance variable range may be changed at some midpoint of the photoconductive layer, although the impedance variable range should be changed at least at one point in a series of plasma processing.

Timing for changing the impedance variable range may be determined as appropriate, but it is preferable that the impedance variable range is changed at the time when a remarkable change in load impedance occurs as plasma processing proceeds in obtaining remarkable effects of the present invention.

After the impedance variable range is determined in advance in this way, cylindrical substrates 405 are placed in a reactor container 401, and gas in the reactor container 401 is exhausted through an exhaust pipe 411 by an exhausting system (not shown) in a plasma processing apparatus shown in FIGS. 4A and 4B. Subsequently, the cylindrical substrate 405 is rotated with a motor 409 via a rotation shaft 408, and the cylindrical substrate 405 is heated by a heating element 407 while control is performed so that it is kept at a predetermined temperature of about 200 to 300°C.

When the temperature of the cylindrical substrate 405 reaches a predetermined temperature, a raw material gas for use in formation of the charge injection blocking layer is introduced into the reactor container 401 via raw material gas supplying means 412. After it is checked that the flow rate of the raw material gas reaches a preset flow rate, and the pressure in the reactor container 401 is stabilized, the output of the high frequency power supply 403 is set at a predetermined value. Subsequently, the impedances of the matching variable condenser 102 and the tuning variable condenser 103 are adjusted so that the output voltage from the phase detector 107 shown in FIG. 1 and the output voltage from the impedance detector 108 approach to reference values, or the power reflectivity observed by watching a power meter is reduced. In addition, the variable range does not necessarily need to be set for the impedances of the matching variable condenser 102 and the tuning variable condenser 103, but it is more preferable that the impedance variable range is set for the impedances in reducing the amount of adjustment time and curbing the variations among lots of plasma processing characteristics. In addition, it is preferable that the impedances of the matching variable condenser 102 and the tuning variable condenser 103 at the time when the adjustment of impedance is started are set at values at which the discharge is most easily produced, and the adjustment of impedance is carried out with the values as starting points in reducing the amount of adjustment time and curbing the variations among lots of plasma processing characteristics.

Through this adjustment of impedance, the high frequency power is efficiently supplied to the reactor container 401 via a cathode (high frequency electrode) 402, and plasma is produced in a film formation space 406 surrounded by the cylindrical substrates 405. When the plasma is produced, the impedance variable ranges for the matching variable condenser 102 and the tuning variable condenser 103 are set at values at the time when formation of the charge injection blocking layer is started, and the adjustment of impedance is carried out. At this time, the impedance variable ranges for the matching variable condenser 102 and the tuning variable condenser 103 are preferably impedance variable ranges in which the values of impedances of the matching variable condenser 102 and the tuning variable condenser 103 at the time when the plasma is produced are included.

Also, the proper impedances of the matching variable condenser 102 and the tuning variable condenser 103 may significantly be varied before and after the plasma is produced. In this case, the variable ranges for impedances of the matching variable condenser 102 and the tuning variable condenser 103 at the time when formation of the charge injection blocking layer is started must be set to be wide, and therefore during formation of the charge injection blocking layer, the variable ranges are preferably changed continuously or in stages so that the impedance variable ranges are gradually narrowed.

When the formation of the charge injection blocking layer is completed, then the photoconductive layer is formed. In the case where the discharge is stopped between the charge injection blocking layer and the photoconductive layer, the supply of high frequency power is stopped after a charge injection blocking layer having a desired thickness is formed, and then the supply of raw material gas is stopped to complete the formation of the charge injection blocking layer. Then, the photoconductive layer is formed using the same procedure as that used when the formation of the charge injection blocking layer was started. At this time, the plasma processing condition, the impedance variable range and the matching goal condition as required are changed to those for formation of the photoconductive layer.

On the other hand, in the case where the charge injection blocking layer and the photoconductive layer are continuously formed without cutting off the discharge, plasma processing conditions such as the flow rate of raw material gas, the high frequency power and pressure are changed continuously and/or in stages to set conditions for formation of the photoconductive layer. How to change the plasma processing condition is not particularly limited, and may be determined as appropriate observing the plasma processing characteristics. Also, for changing the impedance variable range at the time of transition from the charge injection blocking layer to the photoconductive layer, for example, the impedance variable range during formation of the charge injection blocking layer, the impedance variable range when the processing condition is changed, and the impedance variable range during formation of the photoconductive layer may be set at different values, or the impedance variable range during formation of the charge injection blocking layer may be employed until the changing of the processing condition is completed, and the impedance variable range for formation of the photoconductive layer may be set at the time when formation of the photoconductive layer is started, or the impedance variable range for formation of the photoconductive layer may be set at the time when the formation of the charge injection blocking layer is completed, and the same impedance variable range may be employed during the changing of the processing condition and during formation of the photoconductive layer. In the case where the impedance variable range during formation of the charge injection blocking layer, the impedance variable range during the changing of the processing condition, and the impedance variable range during formation of the photoconductive layer are set at different values, for example, a plurality of impedance variable ranges may be set for those during the changing of the processing condition, and the impedance variable range may be changed also during the changing of the processing condition. Because the suitable process for changing the impedance variable range varies depending on desired processing characteristics, plasma processing conditions, configurations of plasma processing apparatus and the like, how to change the impedance variable range may be determined as appropriate in consideration with these factors, but in any case, the impedance variable range should be changed at least at one point in a series of plasma processing.

When the formation of the photoconductive layer is completed in this way, the surface layer is subsequently formed. The procedure of transition from the formation of the photoconductive layer to the formation of the surface layer may be the same as the procedure of transition from the formation of the charge injection blocking layer to the formation of the photoconductive layer.

When the formation of the surface layer is completed in this way, the output of high frequency power is stopped, and the supply of raw material gas is stopped to complete the formation of the electrophotographic photosensitive member.

Furthermore, for the changing of the impedance variable range, both the impedance variable ranges for the matching variable condenser 102 and the tuning variable condenser 103 may be changed or any one thereof may be changed.

Plasma processing using the matching box having the configuration shown in FIG. 1 may be performed in the following way in the case where, for example, the plasma processing apparatus shown in FIGS. 6A and 6B is used to form an electrophotographic photosensitive member constituted of the charge injection blocking layer, photoconductive layer and surface layer. Furthermore, matching boxes 604 and 616 in FIG. 6A both have the internal configuration shown in FIG. 1, but in order to discriminate between members in the matching box 604 and members in the matching box 616, the members in the matching box 604 will be given a symbol "a" and the members in the matching box 616 will be given a symbol "b" for convenience in the description below.

First, prior to formation of the electrophotographic photosensitive member, the impedance of a matching variable condenser 102a and the impedance of a tuning variable condenser 103a in the matching box 604 at which plasma is maintained with stability are determined through a preliminary experiment in advance including variations among lots for conditions of each of the charge injection blocking layer, photoconductive layer and surface layer, and the impedance variable range of the matching variable condenser 102a and the impedance variable range of the matching variable condenser 103a of each layer are determined based on the result of the preliminary experiment. The impedance variable range is determined as appropriate in accordance with plasma formation conditions, the configuration of apparatus to be used, in such a manner that just the range of variations or fluctuations of the impedance of the matching variable condenser 102a and the impedance of the tuning variable condenser 103a obtained from the preliminary experiment is defined as the variable range, or a range approximately twice as wide as the range of variations of impedance is defined as the impedance variable range, for example, so that plasma can be maintained with stability in actual plasma processing. According to the present invention, it is preferable that the impedance variable range is set within a range approximately twice as wide as the range of variations of impedance obtained from the preliminary experiment in maintaining stable plasma. If the impedance of the variable condenser varies between 200 pF and 300 pF according to the preliminary experiment, namely the width of variations of impedance is 100 pF, for example, the impedance variable range of the variable condenser is preferably set to a range twice as wide as the range of variations or fluctuations, namely the width of 200 pF, and in the case of this example, the impedance variable range of the variable condenser is set within the range of from 150 pF to 350 pF.

Similarly, the impedance of a matching variable condenser 102b and the impedance of a tuning variable condenser 103b in the matching box 616 are determined through a preliminary experiment in advance including variations among lots, and the impedance variable range of the matching variable condenser 102b and the impedance variable range of the matching variable condenser 103b of each layer are determined based on the result of the preliminary experiment. The specific impedance variable range is determined in the same manner as the matching box 604.

The impedance variable ranges of the matching variable condensers 102a and 102b and the impedance variable ranges of the tuning variable condensers 103a and 103b of each of the charge injection blocking layer, photoconductive layer and surface layer determined in this way are stored in impedance/phase control units 109a and 109b in advance, and the impedance variable ranges of the matching variable condensers 102a and 102b and the impedance variable ranges of the matching condensers 103a and 103b may be changed in accordance with the timing of switching of layers, or data may be sent from the outside to the impedance/phase control units 109a and 109b in accordance with the timing of switching of layers, or the impedance variable ranges may be changed by other methods.

Also, the number of impedance variable ranges for each layer is not necessarily one, but instead two or more impedance variable layers may be set for each layer. In this case, the impedance variable range is switched to the next impedance variable range at a predetermined midpoint of the layer. Conversely, different impedance variable ranges are not necessarily set for different layers, but instead, for example, the same impedance variable range may be used for the charge injection blocking layer and the photoconductive layer, or the same impedance variable range may be used for the photoconductive layer and the surface layer, or the same impedance variable range may be used for the blocking layer and the initial portion of the photoconductive layer and the impedance variable range may be changed at some midpoint of the photoconductive layer, or the same impedance variable range may be used for all the layers. Furthermore, for obtaining remarkable effects of the present invention, it is preferable that at a suitable point in processing, the impedance variable range is changed to the optimal impedance variable range at this point.

Timing for changing the impedance variable range may be determined as appropriate, but it is preferable that the impedance variable range is changed at the time when a remarkable change in load impedance occurs as plasma processing proceeds in obtaining remarkable effects of the present invention.

The changing of the impedance variable range is not necessarily synchronized for the matching box 604 and the matching box 616, but timing may be different for each of the matching boxes.

After the impedance variable range is determined in advance in this way, cylindrical substrates 605 are placed in a reactor container 601, and gas in the reactor container 601 is exhausted through an exhaust pipe 611 by an exhausting system (not shown). Subsequently, the cylindrical substrate 605 is rotated with a motor (not shown) via a rotation shaft 608, and the cylindrical substrate 605 is heated by a heating element 607 while control is performed so that it is kept at a predetermined temperature of about 200 to 300°C.

When the cylindrical substrate 605 is heated to a predetermined temperature, a raw material gas for use in formation of the charge injection blocking layer is introduced into the reactor container 601 via a raw material gas supply pipe 612. After it is checked that the flow rate of the raw material gas reaches a preset flow rate, and the pressure in the reactor container 601 is stabilized, the outputs of the high frequency power supplies 603 and 615 are set at predetermined values.

When high frequency powers are outputted from the high frequency power supplies 603 and 615, the adjustment of impedance is carried out in the matching boxes 604 and 616. Specifically, the impedances of the matching variable condensers 102a and 102b and the tuning variable condensers 103a and 103b are adjusted, respectively, so that the output voltages from phase detectors 107a and 107b, and the output voltages from impedance detectors 108a and 108b are close to reference voltages. Through this adjustment of impedance, high frequency powers are efficiently supplied to the reactor container 601 via high frequency electrodes 602 and 614, and plasma is produced in the reactor container 601.

Furthermore, this adjustment of impedance during production of plasma is not necessarily carried out automatically. For example, the adjustment of impedance may be carried out manually during production of plasma, and then the operation may be switched to automatic control after it is checked that the plasma has been produced, or plasma may be produced by manually adjusting the impedance, and then the operation may be switched to automatic control after predetermined time elapses.

In addition, when plasma is produced by automatically adjusting the impedance, the variable range is not necessarily set for the impedances of the matching variable condensers 102a and 102b, and the tuning variable condensers 103a and 103b from the time when the production of plasma is started. For example, the impedance variable range may not be set when plasma is produced, and the impedance variable range may be set only after predetermined time elapses after the plasma is produced.

In addition, it is preferable that the impedances of the matching variable condensers 102a and 102b and the tuning variable condenser 103a and 103b at the time of producing plasma are set at values at which the discharge is most easily produced, and the adjustment of impedance is carried out with the values as starting points in reducing the amount of adjustment time and curbing the variations among lots of plasma processing characteristics.

When the plasma is produced in this way, the impedance variable ranges for the matching variable condensers 102a and 102b and the tuning variable condensers 103a and 103b are set at values at the time when formation of the charge injection blocking layer is started, and the adjustment of impedance is carried out. At this time, the impedance variable ranges for the matching variable condensers 102a and 102b and the tuning variable condensers 103a and 103b are preferably impedance variable ranges in which the values of impedances of the matching variable condensers 102a and 102b and the tuning variable condensers 103a and 103b are included.

Also, the proper impedances of the matching variable condensers 102a and 102b and the tuning variable condensers 103a and 103b may significantly be varied before and after the plasma is produced. In this case, the variable ranges for impedances of the matching variable condensers 102a and 102b and the tuning variable condensers 103a and 103b at the time when formation of the charge injection blocking layer is started must be set to be wide, and therefore during formation of the charge injection blocking layer, the variable ranges are preferably changed continuously or in stages so that the impedance variable ranges are gradually narrowed.

After the formation of the charge injection blocking layer is completed, then the photoconductive layer is formed. In the case where the discharge is stopped between the charge injection blocking layer and the photoconductive layer, the supply of high frequency power is stopped after a charge injection blocking layer having a desired thickness is formed, and then the supply of raw material gas is stopped to complete the formation of the charge injection blocking layer. Then, the photoconductive layer is formed through the same step as that taken when the formation of the charge injection blocking layer was started. At this time, the plasma processing condition, the impedance variable range, and the matching goal condition as required are changed to those for formation of the photoconductive layer.

On the other hand, in the case where the charge injection blocking layer and the photoconductive layer are continuously formed without cutting off the discharge, plasma processing conditions such as the flow rate of raw material gas, the high frequency power and pressure are changed continuously and/or in stages to set conditions for formation of the photoconductive layer. How to change the plasma processing condition is not particularly limited, and may be determined as appropriate observing the plasma processing characteristics. Also, for changing the impedance variable range at the time of transition from the charge injection blocking layer to the photoconductive layer, for example, the impedance variable range during formation of the charge injection blocking layer, the impedance variable range when the processing condition is changed, and the impedance variable range during formation of the photoconductive layer may be set at different values, or the impedance variable range during formation of the charge injection blocking layer may be employed until the changing of the processing condition is completed, and the impedance variable range for formation of the photoconductive layer may be set at the time when formation of the photoconductive layer is started, or the impedance variable range for formation of the photoconductive layer may be set at the time when the formation of the charge injection blocking layer is completed, and the same impedance variable range may be employed during the changing of the processing condition and during formation of the photoconductive layer. In the case where the impedance variable range during formation of the charge injection blocking layer, the impedance variable range during the changing of the processing condition, and the impedance variable range during formation of the photoconductive layer are set at different values, for example, a plurality of impedance variable ranges may be set for those during the changing of the processing condition, and the impedance variable range may be changed during the changing of the processing condition. Because the suitable process for changing the impedance variable range varies depending on desired plasma processing characteristics, plasma processing conditions, configurations of plasma processing apparatus and the like, how to change the impedance variable range may be determined as appropriate in consideration with these factors.

When the formation of the photoconductive layer is completed in this way, the surface layer is subsequently formed. The procedure of transition from the formation of the photoconductive layer to the formation of the surface layer may be the same as the procedure of transition from the formation of the charge injection blocking layer to the formation of the photoconductive layer.

When the formation of the surface layer is completed in this way, the output of high frequency power is stopped, and the supply of raw material gas is stopped to complete the formation of the electrophotographic photosensitive member.

Furthermore, for the changing of the impedance variable range, both the impedance variable ranges for the matching variable condensers 102a and 102b and the tuning variable condensers 103a and 103b may be changed or any one thereof may be changed.

Also, in the plasma processing method, two types of high frequency powers having frequencies not lower than 10 MHz and not higher than 250 MHz are supplied, respectively, when a plurality of different high frequency powers are supplied to the reactor container at the same time, and provided that the frequency of the high frequency power having a higher frequency is represented by $f_1$ and the frequency of the high frequency power having a lower frequency is represented by $f_2$, the condition of $0.1 \leq f_2/f_1 \leq 0.9$ is preferably satisfied. The reason for this will be described below.

In the case where a power having a VHF band or a frequency around the VHF band is used to produce plasma to carry out vacuum processing, the wavelength of high frequency power in a vacuum processing container has a length approximately as large as the vacuum processing ontainer, a high frequency electrode, a substrate, a substrate holder or the like, and the high frequency power is apt to form a standing wave in the vacuum processing container, and this standing wave causes the strength of power and thus plasma characteristics to vary area by area in the vacuum processing container. Consequently, it is difficult to keep vacuum processing characteristics uniform over a wide range of area.

As a measure to solve this problem, there is a method in which a plurality of high frequency powers of different frequencies is supplied to the reactor container at the same time. In this way, a plurality of standing waves of different wavelengths consistent with the respective frequencies are formed in the reactor container, but they are supplied at the same time, and therefore these standing waves are combined, so that a distinct standing wave is no longer formed.

However, if the frequencies of a plurality of high frequency powers are different in one order of magnitude or greater, the process in which the raw material gas is decomposed with high frequency powers of higher frequencies differs from the process in which the raw material gas is decomposed with high frequency powers of lower frequencies, and as a result, the types and ratios of generated active species are different. Therefore, even though uniformity is achieved in terms of electric field strength, active species of types and ratios consistent with higher frequencies are generated in large quantities in the loop regions of standing waves formed with high frequency powers of higher frequencies, and active species of types and ratios consistent with lower frequencies are generated in large quantities in the loop regions of standing waves formed with high frequency powers of lower frequencies. As a result, spatial distributions may arise in the type and ratio of active species, resulting in unevenness in vacuum processing characteristics.

On the other hand, the relationship between frequencies $f_1$ and $f_2$ is limited to $f_2/f_1 \geq 0.1$, whereby the level of difference in types and ratios of generated active species caused by the difference in frequencies is reduced to a level that does not cause a problem from a viewpoint of practical use, thus making it possible to achieve a high level of evenness in vacuum processing characteristics.

Also, if the frequencies $f_1$ and $f_2$ are too close to each other, the node position and loop position of each standing wave are close to each other, and therefore adequate effects of inhibiting electric field standing waves can no longer be obtained. Therefore, it is also necessary to limit the relationship between frequencies $f_1$ and $f_2$ to $0.9 \geq f_2/f_1$ in obtaining a high level of evenness in vacuum processing characteristics.

In addition, if the frequency $f_1$ is higher than 250 MHz, there may be cases where attenuation of power in the onward direction is significant, and thus there arise considerable differences in attenuation factors between high frequency powers having different frequencies, thus making it impossible to obtain adequate effects of achieving evenness. In addition, if the frequency $f_2$ is lower than 10 MHz, the vacuum processing speed rapidly decreases, resulting in a preferred situation in terms of cost.

From the above, it is very effective in maintaining the vacuum processing speed at a high level while improving evenness in vacuum processing characteristics to limit the relationship between the frequencies $f_1$ and $f_2$ to the following inequality.

$$250\ MHz \geq f1 > f2 \geq 10\ MHz$$

$$0.9 \geq f2/f1 \geq 0.1$$

However, if a plurality of high frequency powers in the above frequency range is used, interference tends to occur as described previously, and plasma stability may be insufficient in the conventional method of adjusting the impedance.

In contrast to this, in the method of the present invention of adjusting the impedance, the influence by this interference is curbed to enable the plasma to be maintained with stability and good reproducibility, and therefore a problem found when the conventional method of adjusting the impedance is solved, thus making it possible to obtain generally excellent vacuum processing characteristics with high evenness and less variations in vacuum processing characteristics.

In addition, the frequencies of high frequency powers particularly preferably satisfy the condition of $0.5 < f_2/f_1 \leq 0.9$. By setting this range, the effect of improving evenness is further enhanced, and plasma stability is ensured by the method of the present invention of adjusting the impedance, thus making it possible to generally excellent vacuum processing characteristics.

According to the above described plasma processing apparatus and plasma processing method, the adjustment of impedance by the matching device is carried out automatically in a predetermined impedance variable range, and thereby the matching of impedance by the matching device is carried out properly and stably, thus making it possible to achieve the improvement of plasma processing characteristics, the improvement of reproducibility of plasma processing characteristics and reduction in cost for plasma processing.

The plasma processing apparatus according to the present invention is a plasma processing apparatus capable of supplying a plurality of high frequency powers to the reactor container at the same time, and is identical in basic configuration to the plasma processing apparatus shown in FIGS. 6A and 6B.

Furthermore, the plasma processing apparatus according to the present invention may be applied for another plasma processing apparatus comprising a dielectric wall. Another plasma processing apparatus according to the present invention will be described with reference to the drawings.

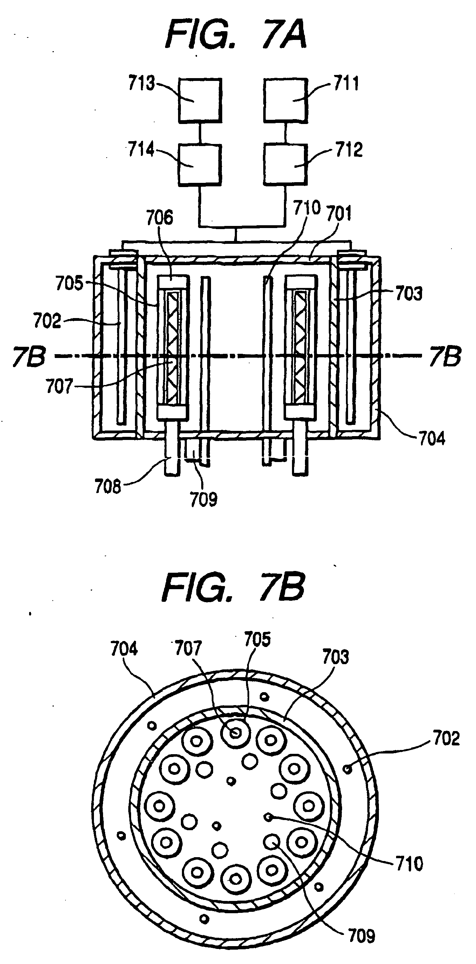

FIG. 7A is a cross sectional view of the plasma processing apparatus, and FIG. 7B is a cross sectional view taken along the 7B-7B line in FIG. 7A. An exhaust port 709 is provided in the bottom of a reactor container 701, and the other end of this exhaust port 709 is connected to an exhaust system (not shown).

Twelve cylindrical substrates 705 on which a deposition film is to be formed are installed while being placed on a holder 706, in such a manner as to surround the central portion and in parallel with one another in the reactor container 701 provided in this plasma processing apparatus.

Each cylindrical substrate 705 is supported by a rotation shaft 708, and is heated by a heating element 707. By driving a motor (not shown), the rotation shaft 708 is rotated, and the cylindrical substrate 705 is thereby rotated around the central axis in the bus line direction thereof. The cylindrical substrate 705 is kept at a ground potential through the rotation shaft 708. A raw material gas is supplied from a raw material gas supply pipe 710 to the reactor container 701.

A cylindrical dielectric wall 703 made of alumina is provided in a part of reactor container 701. Six rod-shaped high frequency electrodes 702 are installed in parallel with one another outside the cylindrical dielectric wall 703, and a high frequency power shield 704 is provided outside these high frequency electrodes 702.

The high frequency power outputted from a high frequency power supply 711 is supplied to the high frequency electrode 702 via a matching box 712. The high frequency power supply 711 and the matching box 712 are electrically connected together via a coaxial cable. Also, the high frequency power outputted from a high frequency power supply 713 is supplied to the high frequency electrode 702 via a matching box 714. The high frequency power supply 713 and the matching box 714 are electrically connected together via a coaxial cable.

Also, the matching boxes provided in this plasma processing apparatus each have a configuration identical to that of the matching box shown in FIG. 1, and there description thereof is not presented here.

Examples

The present invention will be more in detail below using Examples, but the present invention is not limited thereto.

Example 1

Using a plasma processing apparatus shown in FIGS. 4A and 4B and a matching box of a matching device having a configuration shown in FIG. 1, ten lots of a-Si based photosensitive members (total 60 members) each constituted of a charge injection blocking layer, a photoconductive layer and a surface layer were fabricated on cylindrical substrates 405 each being an aluminum cylinder having a diameter of 80 mm and a length of 358 mm in accordance with the conditions shown in Table 1, with the oscillation frequency of a high frequency power supply 403 set at 100 MHz. In Table 1, the high frequency power shows an effective power obtained by subtracting a reflected power from an incident power. A cathode (high frequency electrode) 402 is an SUS cylinder having a diameter of 20 mm, of which outer face was covered with an alumina pipe having an inner diameter of 21 mm and an outer diameter of 24 mm. The alumina pipe was subjected to blast processing so that its surface roughness level was 20 $\mu$m in Rz with standard length of 2.5 mm. As for the cylindrical substrate, six cylindrical substrates 405 were arranged at equal intervals on the same circumference.

Also, a matching variable condenser 102 was variable in the 50 to 1,000 pF range, and a tuning variable condenser 103 was variable in the 5 to 250 pF range. The output of the high frequency power supply 403 was 50 $\Omega$, and was linked to the matching box 404 by a coaxial cable having a characteristic impedance of 50 $\Omega$.

The impedance variable ranges for the matching variable condenser 102 and the tuning variable condenser 103 were first determined using this apparatus.

First, the cylindrical substrate 405 was installed on a rotation shaft 408 in a reactor container 401. Thereafter, gas in the reactor container 401 was exhausted through an exhaust pipe 411 by an exhaust system (not shown). Subsequently, the cylindrical substrate 405 was rotated at the speed of 10 rpm with a motor (not shown) via the rotation shaft 408, and 500 ml/min (normal) of argon (Ar) gas was supplied to the reactor container 401 from raw material gas supplying means 412 while the cylindrical substrate 405 was heated by a heating element 407 with control being performed so that its temperature kept at 250°C and this state was maintained for two hours.

Then, the supply of Ar gas was stopped, and gas in the reactor container 401 was exhausted through the exhaust pipe 411 by the exhaust system (not shown), followed by introducing a raw material gas for use in formation of a charge injection blocking layer shown in Table 1 via the raw material gas supplying means 412. After it was checked that the flow rate of raw material gas reached a preset flow rate, and the pressure in the reactor container 401 was stabilized, the output of the high frequency power supply 403 was set to a value equivalent to 20% of the condition of the charge injection blocking layer shown in Table 1. In this condition, the capacity of the matching variable condenser 102 in the matching box 404 was adjusted so that the difference between an output voltage from an impedance detector 108 and a reference voltage was reduced. The reference voltage was set to the value of output voltage from the impedance detector 108 with the impedance at the high frequency power input point of the matching box 404 on the load side being considered as 50 $\Omega$. At the same time, the capacity of the tuning variable condenser 103 in the matching box 404 was adjusted so that the difference between an output voltage from a phase detector 107 and a reference voltage was reduced. The reference voltage was set to the value of output voltage from the phase detector 107 with phase difference between the incident power at the high frequency power input point of the matching box 404 on the load side and the reflected power being considered as 0 degree.

After the capacities of the matching variable condenser 102 and the tuning variable condenser 103 were adjusted so that the difference between the output voltage from the impedance detector 108 and the reference voltage and the difference between the output voltage from the phase detector 107 and the reference voltage were minimized in this way, the output of the high frequency power supply 403 was increased to a value equivalent to the condition of the charge injection blocking layer shown in Table 1 to produce a discharge, and the capacity of each variable condenser at the time when the discharge was produced was determined. Subsequently, the charge injection blocking layer was formed. When the formation of the charge injection blocking layer was started, the capacities of the matching variable condenser 102 and the tuning variable condenser 103 were adjusted again so that the absolute value of impedance at the input point of the matching box 404, and the phase difference between the incident voltage and the reflected voltage are minimized. This adjustment was carried out at intervals of two minutes during formation of the charge injection blocking layer, and the variation ranges of capacities of the matching variable condenser 102 and the tuning variable condenser 103 were determined.

When the formation of the charge injection blocking layer was completed, the output of high frequency power was stopped, plasma processing conditions such as a gas type, gas flow rate, pressure and the like were switched to conditions for formation of the photoconductive layer shown in Table 1, and the capacities of the matching variable condenser 102 and the tuning variable condenser 103 during production of discharge, and the variation ranges of capacities of the matching variable condenser 102 and the tuning variable condenser 103 during formation of the photoconductive layer were determined in the same manner as formation of the charge injection blocking layer.

Similarly, the capacities of the matching variable condenser 102 and the tuning variable condenser 103 during production of discharge for the surface layer, and the variation ranges of capacities of the matching variable condenser 102 and the tuning variable condenser 103 during formation of the surface layer were determined.

This experiment was conducted ten times to determine the variation ranges of capacities of the matching variable condenser 102 and the tuning variable condenser 103 during production of discharge for the charge injection blocking layer, photoconductive layer and surface layer, and the variation ranges of capacities of the matching variable condenser 102 and the tuning variable condenser 103 during formation of those layers were determined.

The results are shown in Table 2. Based on the results, the variation ranges of capacities of the matching variable condenser 102 and the tuning variable condenser 103 during production of discharge for the charge injection blocking layer, photoconductive layer and surface layer and during formation of those layers were determined so that the two conditions of:

(1) the center of the capacity variable range is the center of the capacity variation in Table 2; and
(2) the capacity variable range is twice as wide as the capacity variation range in Table 2, were satisfied, namely ranges as shown in Table 3 were determined.

Table 1

|  | Charge Injection Blocking Layer | Photoconductive Layer | Surface Layer |
|---|---|---|---|
| Type of Gas and Flow Rate $SiH_4$ (ml/min (normal)) $H_2$ (ml/min (normal)) $B_2H_6$ (ppm) Relative to $SiH_4$ $CH_4$ (ml/min (normal)) NO (ml/min (normal)) | 300 300 1,000 15 | 600 200 1.8 | 5 55 |
| Substrate Temperature (°C) | 270 | 270 | 250 |
| Internal Pressure (Pa) | 2.0 | 1.0 | 1.5 |
| High Frequency Power (W) | 800 | 2,000 | 600 |
| Pilm Thickness ($\mu$m) | 3 | 27 | 0.5 |

Table 2

|  | Starting of BL Discharge | Forming of BL | Starting of PCL Discharge | Forming of PCL | Starting of SL Discharge | Forming of SL |
|---|---|---|---|---|---|---|
| MC capacity Variation Range (pP) | 680 - 720 | 700 - 810 | 430 - 480 | 470 - 550 | 510 - 530 | 530 - 570 |
| TC Capacity Variation Range (pF) | 78 - 96 | 72 - 80 | 88 - 116 | 82 - 98 | 94 - 102 | 92 - 108 |
| MC: Matching Condenser, TC: Tuning Condenser BL: Charge Injection Blocking Layer, PCL: Photoconductive Layer, SL: surface Layer | | | | | | |

Table 3

| | Starting of BL Discharge | Forming of BL | Starting of PCL Discharge | Forming of PCL | Starting of SL Discharge | Forming of SL |
|---|---|---|---|---|---|---|
| MC Capacity Variable Range (pF) | 660 - 740 | 645 - 865 | 405 - 503 | 430 - 590 | 500 - 540 | 510 - 590 |
| TC Capacity Variable Range (pF) | 74 - 90 | 68 - 84 | 74 - 130 | 74 - 106 | 90 - 106 | 84 - 116 |

MC: Matching Condenser, TC: Tuning Condenser
BL: Charge Injection Blocking Layer, PCL, Photoconductive Layer.
SL: Surface Layer

After the variable ranges of capacities of the matching variable condenser 102 and the tuning variable condenser 103 were determined, ten lots of electrophotographic photosensitive members were fabricated in the following way according to the conditions shown in Table 1.

First, the cylindrical substrate 405 was installed on a rotation shaft 408 in a reactor container 401. Thereafter, gas in the reactor container 401 was exhausted through an exhaust pipe 411 by an exhaust system (not shown). Subsequently, the cylindrical substrate 405 was rotated at the speed of 10 rpm with a motor (not shown) via the rotation shaft 408, and 500 ml/min (normal) of Ar gas was supplied to the reactor container 401 from raw material gas supplying means 412 while the cylindrical substrate 405 was heated by a heating element 407 with control being performed so that its temperature kept at 250°C and this state was maintained for two hours.

Then, the supply of Ar gas was stopped, and gas in the reactor container 401 was exhausted through the exhaust pipe 411 by the exhaust system (not shown), followed by introducing via the raw material supplying means 412 a raw material gas for use in formation of the charge injection blocking layer shown in Table 1. After it was checked that the flow rate of raw material gas reached a preset flow rate, and the pressure in the reactor container 401 was stabilized, the output of the high frequency power supply 403 was set to a value equivalent to 20% of the condition of the charge injection blocking layer shown in Table 1. In this state, the adjustment of capacities of the matching condenser 102 and the tuning condenser 103 was carried out within the range shown in Table 3. Specifically, at the inlet of the matching circuit 101, a high frequency current was detected by a current detection element 105, and a high frequency voltage was detected by a voltage detection element 106. The outputs of the current detector element 105 and the voltage detection element 106 were inputted to the phase difference detector 107 and the impedance detector 108 in the control system 100. In the phase difference detector 107, the phase of impedance at the inlet of the matching circuit 101 was detected, and an impedance/phase control unit 109 was made to output a voltage consistent with the phase of impedance. In the impedance/phase control unit 109, the impedance of the tuning variable condenser 103 was controlled based on the voltage inputted from the phase difference detector 107 within the preset variable range at the time of the starting of discharge for the charge injection blocking layer shown in Table 3. That is, the voltage inputted from the phase difference detector 107 was compared with a reference voltage, and a voltage consistent with the difference therebetween was supplied to a motor 110 for driving the tuning variable condenser 103 to adjust the impedance so that the difference between the voltage inputted from the phase difference detector 107 and the reference voltage was reduced. In this case, when the impedance of the tuning variable condenser 103 reached the maximum or minimum value in the variable range at the time of the starting of discharge for the charge injection blocking layer shown in Table 3, the supply of voltage to the motor 110 was immediately stopped to prevent the capacity variable range shown in Table 3 from being exceeded. The reference voltage was set to the value of output voltage from the phase detector 107 with the phase difference between incident voltage and reflected voltage at the high frequency power input point of the matching box 404 on the load side being considered as 0 degree.

On the other hand, in the impedance detector 108, the absolute value of impedance at the inlet of the matching circuit 101 was detected, the impedance/phase control unit 109 was made to output a voltage consistent with the absolute value of impedance. In the impedance/phase control unit 109, the impedance of the matching variable condenser 102 was controlled based on the voltage inputted from the impedance detector 108 within the preset variable range at the time of the starting of discharge for the charge injection blocking layer shown in Table 3. That is, the voltage inputted from the impedance detector 108 was compared with a reference voltage, and a voltage consistent with the difference therebetween was supplied to a motor 112 for driving the matching variable condenser 102 to adjust the impedance so that the difference between the voltage inputted from the impedance detector 108 and the reference voltage was reduced.

In this case, when the impedance of the matching variable condenser 102 reached the maximum or minimum value in the variable range shown in Table 3, the supply of voltage to the motor 112 was Immediately stopped to prevent the capacity variable range shown in Table 3 from being exceeded. The reference voltage was set to the value of output voltage from the impedance detector 108 with the impedance at the high frequency power input point of the matching box 404 on the load side being considered as 50 Ω.

In this way, the impedances of the matching variable condenser 102 and the tuning variable condenser 103 were adjusted while the output of the high frequency power supply 403 was increased to the value for the charge injection blocking layer shown in Table 1, whereby a discharge was produced to start formation of the charge injection blocking layer. When the formation of the charge injection blocking layer was started, the set variable ranges of capacities of the matching variable condenser 102 and the tuning variable condenser 103 were changed to the variable ranges to be applied during formation of the charge injection blocking layer shown in Table 3. In the impedance/phase control unit 109, the capacity of the tuning variable condenser 103 was adjusted within the changed capacity variable range. A control method was employed in which when the capacity of the tuning variable condenser 103 reaches the maximum or minimum value in the variable range, or the difference between the voltage inputted from the phase detector 107 and the reference voltage reached a level lower than or equal to the matching goal condition, the supply of voltage to the motor 110 is stopped. The reference voltage was set to the value of output voltage from the phase detector 107 with the phase difference between incident voltage and reflected voltage at the high frequency power input point of the matching box 404 on the load side being considered as 0 degree. The matching goal condition was set such that the difference between the voltage inputted from the phase detector 107 and the reference voltage is smaller than or equal to 5% of the reference voltage.

At the same time, in the impedance/phase control unit 109, the capacity of the matching variable condenser 102 was adjusted within the changed capacity variable range. A control method was employed in which when the capacity of the matching variable condenser 102 reaches the maximum or minimum value in the variable range, or the difference between the voltage inputted from the impedance detector 108 and the reference voltage reached a level lower than or equal to the matching goal condition, the supply of voltage to the motor 112 is stopped. The reference voltage was set to the value of output voltage from the impedance detector 108 with the impedance at the high frequency power input point of the matching box 404 on the load side being considered as 50 Ω. The matching goal condition was set such that the difference between the voltage inputted from the impedance detector 108 and the reference voltage is smaller than or equal to 5% of the reference voltage.

After the formation of the charge injection blocking layer was completed in this way, the outputting of high frequency power was stopped, plasma processing conditions such as the type of gas, the flow rate of gas and pressure were set to the conditions for formation of the photoconductive layer shown in Table 1, and the set variable ranges of capacities of the matching variable condenser 102 and the tuning variable condenser 103 were changed the ranges to be applied at the time of starting discharge for the photoconductive layer shown in Table 3, followed by producing a discharge in the same way as the formation of the charge injection blocking layer to form the photoconductive layer.

After the formation of the photoconductive layer was completed, the outputting of high frequency power was stopped, plasma processing conditions such as the type of gas, the flow rate of gas and pressure were set to the conditions for formation of the surface layer shown in Table 1, and the set variable ranges of capacities of the matching variable condenser 102 and the tuning variable condenser 103 were changed the ranges to be applied at the time of starting discharge for the surface layer shown in Table 3, followed by producing a discharge in the same manner as the formation of the charge injection blocking layer to form the surface layer.

In this way, ten lots of electrophotographic photosensitive members (total 60 members) each constituted by a charge injection blocking layer, a photoconductive layer and a surface layer were fabricated. The electrophotographic photosensitive member was formed stably in every lot.

Comparison example 1

Ten lots of electrophotographic photosensitive members (total 60 members) each constituted of a charge injection blocking layer, a photoconductive layer and a surface layer were fabricated in the same manner as Example 1 except that the variable ranges of capacities of the matching variable condenser 102 and the tuning variable condenser 103 were not set. As a result, the capacities of the matching variable condenser 102 and the tuning variable condenser 103 were considerably deviated from stable points temporarily to destabilize a discharge during formation of the electrophotographic photosensitive member in three lots.

Amorphous silicon (a-Si) photosensitive members fabricated in this way in Example 1 and Comparison example 1 were installed in a copier (NP-6750, manufactured by Canon Inc.) modified for proper testing to evaluate the characteristics of the photosensitive members. Evaluations were made for four items, namely "unevenness of image density," "photomemory," "variation of properties" and "image defect" using the following specific evaluation methods.

Unevenness of Image Density

First, the current of a main electrifier was adjusted so that the value of dark area potential at the developer position was a constant value, and thereafter a given white paper with reflection density of 0.1 or lower was used as an original to adjust the amount of image light exposure so that the value of light area potential at the developer position was a predetermined value. Then, a half tone chart manufactured by Canon Inc. (part number: FY9-9042) was placed on a script pad, and an evaluation was made based on a difference between the maximum and minimum values of reflection density in the entire area of a copy image obtained by coping. The average value for all photosensitive members was used as the evaluation result. Thus, the smaller the value, the better the result is.

Photomemory

The current value of the main electrifier was adjusted so that the value dark area potential at the developer position was a predetermined value, and thereafter the amount of image light exposure was adjusted so that the value of light area potential was a predetermined value using a given white paper as an original. In a copy image obtained in such a manner that in this state, a ghost test chart manufactured by Canon Inc. (part number: FY9-9040) having a black circle with reflection density of 1.1 and a diameter of 5 mm attached thereto was placed on the script pad, and the half tone chart manufactured by Canon Inc. was superimposed thereon, a difference between the reflection density of the black circle with a diameter of 5 mm of the ghost chart found on the half tone copy and the reflection density of the half tone part was determined to make an evaluation. Photomemory measurement was carried out for the entire area in the bus line direction of the photosensitive member (entire area along the longitudinal direction of the photosensitive member), and an evaluation was made based on a difference their maximum reflection densities. The average value for all photosensitive members was used as the evaluation result. Thus, the smaller the value, the better the result is.

Variation of properties

Maximum and minimum values of the evaluation results for all photosensitive members in the above "photomemory" evaluation were determined, and then the value of (maximum value)/(minimum value) was calculated. Thus, the smaller the value, the smaller the variation of properties is, and thus the better the result is.

Image Defect

White dots with diameters of 0.1 mm or greater in the same area of the copy image obtained by placing the half tone chart manufactured by Canon Inc. (part number: FY9-9042) on the script pad to perform copying were counted, and an evaluation was made based on the counted number. Thus, the smaller the value, the better the result is.

Results of evaluation are shown in Table 4. In Table 4, the evaluation results are based on those in Comparison Example 1. The unevenness of image density is evaluated with reference to the evaluation results of Comparison Example 1 in accordance with the following criteria: a symbol AA indicates an improvement to less than 1/4 in difference between maximum reflection densities; a symbol AA - A indicates an improvement to 1/4 or more and less than 1/2; a symbol A indicates an improvement to 1/2 or more and less than 3/4; a symbol A - BB indicates an improvement to 3/4 or more; a symbol BB indicates equivalence; and a symbol C indicates a degradation. In addition, the "variation of properties" was evaluated in accordance with the following criteria: a symbol AA indicates an improvement of 40% or more; a symbol A Indicates an improvement of 20% or more and less than 40%; a symbol BB indicates an improvement of 10% or more and less than 20%; a symbol B indicates an improvement of less than 10% or a deterioration of less than 10%; and a symbol C indicates a deterioration of 10% or more. The photomemory was evaluated in accordance with the following criteria: a symbol AA indicates an improvement to less than 1/4 in difference between maximum reflection densities; a symbol AA - A indicates an improvement to 1/4 or more and less than 1/2; a symbol A indicates an improvement to 1/2 or more and less than 3/4; a symbol A - BB indicates an improvement to 3/4 or more; a symbol BB indicates equivalence; and a symbol C indicates a degradation. The image defect was evaluated in accordance with the following criteria: a symbol AA indicates an improvement to less than 1/4 in the number of white dots with diameters 0.1 mm or greater; a symbol AA - A indicates an improvement to 1/4 or more and less than 1/2, a symbol A indicates an improvement to 1/2 or more and less than 3/4; a symbol A - BB indicates an improvement to 3/4 or more; a symbol BB indicates equivalence; and a symbol C indicates a degradation.

Electrophotographic photosensitive members fabricated in Example 1 showed good results in all evaluation items to demonstrate the effect of the present invention. In addition, the electrophotographic images formed in Example 1 using the electrophotographic photosensitive members had no image smears and were thus quite satisfactory.

Table 4

| | Unevenness of Image Density | Photomemory | Variation of Properties | Image Defect |
|---|---|---|---|---|
| Example 1 | A - BB | A - BB | A | A |

Example 2

The deposition film forming apparatus and the matching box used in Example 1 were used to determine matching goal conditions to be applied during formation of the charge injection blocking layer, photoconductive layer and surface layer under the conditions shown in Table 1 according to the following procedure.

First, formation of the charge injection blocking layer was started using a same procedure as used in determination of impedance variable ranges in Example 1. When the formation of the charge injection blocking layer was started, the capacities of the matching variable condenser 102 and the tuning variable condenser 103 were changed within 10% or smaller of power reflectivity while observing the incident power and reflected power at the high frequency power input point of the matching box 404, and thereby the maximum value of difference between the voltage outputted from the phase detector 107 and the phase reference voltage, and the maximum value of difference between the voltage outputted from the impedance detector 108 and the impedance reference voltage were determined. Furthermore, the power reflectivity is a ratio of reflected power to the incident power. In addition, the phase reference voltage is set to the value of output voltage from the phase detector 107 with the phase difference between incident voltage and reflected voltage at the high frequency power input point of the matching box 404 on the load side being considered as 0 degree, while the impedance reference voltage was set to the value of output voltage from the impedance detector 108 with the impedance at the high frequency power input point of the matching box 404 on the load side being considered as 50 Ω.

This measurement of the maximum value of difference between the voltage outputted from the phase detector 107 and the phase reference voltage and the maximum value of difference between the voltage outputted from the impedance detector 108 and the impedance reference voltage was carried out during the formation of the charge injection blocking layer at intervals of two minutes, and the largest maximum value among them was used to determine the phase matching goal condition and the impedance matching goal condition described below.

$$\text{Phase matching goal condition (\%)} = \{(\text{maximum vale of difference between voltage outputted from phase detector 107 and phase reference voltage})/(\text{phase reference voltage})\} \times 100$$

$$\text{Impedance matching goal condition (\%)} = \{(\text{maximum value of difference between voltage outputted from impedance detector 108 and impedance reference voltage})/(\text{impedance reference voltage})\} \times 100$$

Similarly, the matching goal conditions applied during formation of the photoconductive layer and formation of the surface layer were determined. As a result, matching goal conditions as shown in Table 5 were obtained for each layer.

Table 5

| | Charge Injection Blocking Layer | Photoconductive Layer | Surface Layer |
|---|---|---|---|
| Phase Matching Goal Condition | 4% | 2% | 5% |

(continued)

|  | Charge Injection Blocking Layer | Photoconductive Layer | Surface Layer |
|---|---|---|---|
| Impedance Matching Goal Condition | 3% | 2% | 4% |

After the matching goal conditions applied during formation of each layer were determined, ten lots of electrophotographic photosensitive members (total 60 members) each constituted of a charge injection blocking layer, a photoconductive layer and a surface layer were fabricated under the conditions shown in Table 1 in the same manner as Example 1. In this Example, however, the matching goal conditions were set at the values shown in FIG. 5 for each of the charge injection blocking layer, photoconductive layer and surface layer. That is, the matching goal condition was changed during formation of the electrophotographic photosensitive member.

The electrophotographic photosensitive member was formed stably in every lot.

Comparison Example 2

Ten lots of electrophotographic photosensitive members (total 60 members) each constituted of a charge injection blocking layer, a photoconductive layer and a surface layer were fabricated under the conditions shown in Table 1 in the same manner as Comparison Example 1 except that both the phase matching goal condition and impedance matching goal condition were set at 2% as in the case of conditions for the photoconductive layer in Example 2 in all the charge injection blocking layer, photoconductive layer and surface layer.

As a result, the capacities of the matching variable condenser 102 and the tuning variable condenser 103 were always varied in all the lots during formation of the surface layer, thus making it impossible to form the electrophotographic photosensitive member with stability.

The a-Si photosensitive members fabricated in this way in Example 2 and Comparison Example 2 were installed in a copier (NP-6750, manufactured by Canon Inc.) modified for proper testing to evaluate the characteristics of the photosensitive members. Evaluations were made for four items, namely "unevenness of image density," "photomemory," "variation of properties" and "image defect" using specific evaluation methods same as those in Example 1.

Results of evaluation are shown in Table 6. Table 6 shows results of evaluation conducted in the same manner as Example 1 with reference to the evaluation results of Comparison Example 1.

The electrophotographic photosensitive member fabricated in Example 2 showed good results in all the evaluation items to demonstrate the effect of the present invention. In addition, the electrophotographic photosensitive member fabricated in Example 2 had better properties than the electrophotographic photosensitive member fabricated in Example 1. It has been shown by the comparison between Example 2 and Comparative Example 2 that this effect of Example 2 is due to not just the fact that the matching goal condition was narrowed compared to Example 1, but the fact that the impedance variable range was changed as plasma processing proceeded, and the matching goal condition was also changed as plasma processing proceeded.

Table 6

|  | Unevenness of Image Density | Photomemory | Variation of Properties | Image Defect |
|---|---|---|---|---|
| Example 2 | A | A | AA | AA - A |
| Comparison Example 2 | C | C | C | C |

Example 3

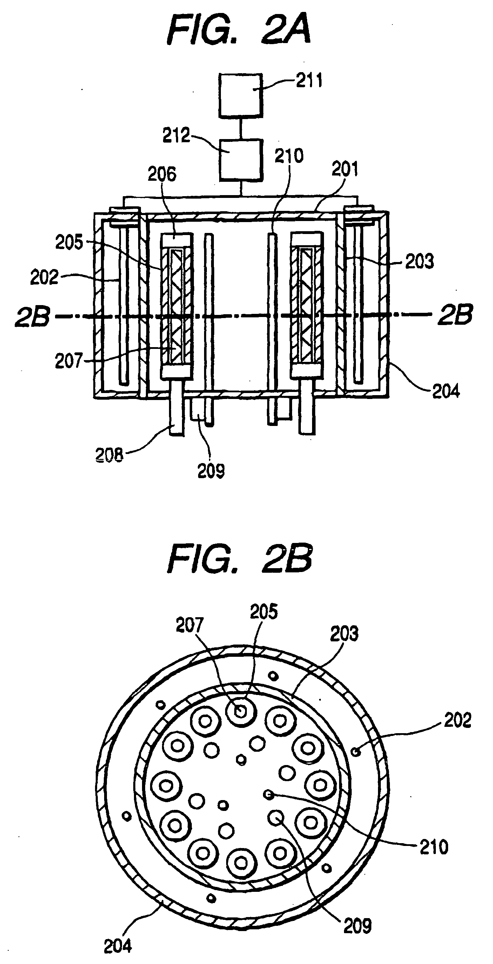

The deposition film forming apparatus shown in FIG. 2 was used to form a-Si photosensitive members under the conditions shown in Table 7. In FIGS. 2A and 2B, FIG. 2A is a schematic sectional view of the deposition film forming apparatus, and FIG. 2B is a schematic sectional view taken along the cutting plane line 2B-2B in FIG. 2A. An exhaust opening 209 is provided in the bottom of a reactor container 201, and the other end of the exhaust opening 209 is connected to an exhaust system (not shown). Twelve cylindrical substrates 205 being aluminum cylinders with diameters of 30 mm and lengths of 358 mm on which a deposition film is to be formed are installed while being placed on a holder 206, in such a manner as to surround the central portion of the reactor container 201 and in parallel with one another. The cylindrical substrate 205 is supported on a rotation shaft 208, and is heated by a heating element 207. A motor (not shown) is driven, whereby the rotation shaft 208 is rotated, and the cylindrical substrate 205 rotates around the central axis in the bus line direction (central axis along the length of the cylindrical substrate). The cylindrical substrate 205 is kept at a ground potential via the rotation shaft 208.

A raw material gas is supplied to the reactor container 201 from raw material gas supplying means 210. The raw material gas supplying means 210 is an alumina pipe with an inner diameter of 10 mm and an outer diameter of 13 mm, has its ends sealed, and is capable of supplying a raw material gas from a gas blast nozzle with a diameter of 1.2 mm provided on the pipe. The raw material gas supplying means 210 has its surface subjected to blast processing so that its surface roughness level is 20 $\mu$m in Rz with standard length of 2.5 mm.

Six rod-shaped high frequency electrodes 202 are placed in parallel with one another outside an alumina cylindrical dielectric wall 203 constituting a part of the reactor container 201, and further outside thereof, a high frequency power shield 204 is provided in such a manner as to cylindrically surround the cylindrical dielectric wall 203.

The frequency of a high frequency power supply 211 is 60 MHz, and the high frequency power outputted from the high frequency power supply 211 is supplied to the high frequency electrode 202 via a matching box 212. The output impedance of the high frequency power supply 211 is 50 $\Omega$, and the high frequency power supply 211 and the matching box 212 are connected together by a coaxial cable having a characteristic impedance of 50 $\Omega$. The high frequency electrode 202 is an SUS cylinder with a diameter of 20 mm. In addition, the alumina cylindrical dielectric wall 203 constituting a part of the reactor container 201 has its inner surface subjected to blast processing so that its surface roughness level is 20 $\mu$m in Rz with standard length of 2.5 mm. In addition, the matching box 212 has as its specific configuration a configuration shown in FIG. 1, and the matching variable condenser 102 is variable within the range of from 50 pF to 1,000 pF while the tuning variable condenser 103 is variable within the range of from 5 pF to 250 pF.

Using this apparatus, impedance variable ranges were determined in the same manner as Example 1 under the conditions shown in Table 7. Then, matching goal conditions were determined in the same manner as Example 2 under the conditions shown in Table 7. Furthermore, after formation of a charge transport layer, the flow rate of gas was continuously changed in 5 minutes without stopping a discharge, and thereafter the power was changed in 5 minutes to form a next layer, namely a charge generation layer. In addition, after formation of the charge generation layer, the flow rate of gas, the power and the pressure were continuously changed in 15 minutes without stopping the discharge to form a next layer, namely a surface layer. In this way, the impedance variable ranges and the matching goal conditions were determined.

Table 7

| | Charge Transport Layer | Charge Generation Layer | Surface Layer |
|---|---|---|---|
| Type of Gas and Flow Rate $SiH_4$ (ml/min (normal)) $H_2$ (ml/min (normal)) $B_2H_6$ (ppm) Relative to $SiH_4$ $CH_4$ (ml/min (normal)) | 300 450 8 → 1.5 300 → 0 | 200 800 1.5 | 15 200 |
| Substrate Temperature (°C) | 250 | 250 | 250 |
| Internal Pressure (Pa) | 7 → 4 | 4 | 3 |
| High Frequency Power (W) | 1,200 | 800 | 400 |
| Thickness ($\mu$m) | 25 | 5 | 0.5 |

Table 8

| | Starting of Discharge | Forming of Charge Transport Layer | Change Area | Forming of Charge Generation Layer | Change Area | Forming of Surface Layer |
|---|---|---|---|---|---|---|
| MC Capacity Variable Range (pF) | 890 - 910 | 740 - 870 | Continuously changed | 710 - 840 | Continuously changed | 510 - 550 |

(continued)

| | Starting of Discharge | Forming of Charge Transport Layer | Change Area | Forming of Charge Generation Layer | Change Area | Forming of Surface Layer |
|---|---|---|---|---|---|---|
| Phase matching Goal Condition | | 2 % | Continuously Changed | 3 % | Continuously changed | 5 % |
| Impedance Matching Goal Condition | | 2% | 2% | 2% | Continuously Changed | 4% |
| MC: Matching Condenser | | | | | | |

These impedance variable ranges and matching goal conditions were used to fabricate five lots of electrophotographic photosensitive members under the conditions shown in Table 7 according to the following general procedure.

First, the cylindrical substrate 205 being a cylindrical aluminum cylinder supported on the substrate holder 206 was placed on the rotation shaft 208 in the reactor container 201. Thereafter, gas in the reactor container 201 was exhausted through the exhaust pipe 209 by the exhaust system (not shown). Subsequently, the cylindrical substrate 205 was rotated at the speed of 10 rpm with a motor (not shown) via the rotation shaft 208, and 500 ml/min (normal) of Ar gas was supplied to the reactor container 201 from raw material gas supplying means 210 while the cylindrical substrate 205 was heated by a heating element 207 with control being performed so that its temperature was kept at 250°C and this state was maintained for two hours.

Then, the supply of Ar gas was stopped, and gas in the reactor container 201 was exhausted through the exhaust pipe 208 by the exhaust system (not shown), followed by introducing via the raw material supplying means 210 a material gas for use in formation of the charge transport layer shown in Table 7. After it was checked that the flow rate of raw material gas reached a preset flow rate, and the pressure in the reactor container 201 was stabilized, the output of the high frequency power supply 211 was set to a value equivalent to 20% of the condition of the charge transport layer shown in Table 7. In this state, the adjustment of capacities of the matching condenser 102 and the tuning condenser 103 was carried out. The specific control method was similar to that of Example 1.

In this way, the impedances of the matching variable condenser 102 and the tuning variable condenser 103 were adjusted while the output of the high frequency power supply 211 was increased to the value for the charge transport layer shown in Table 7, whereby a discharge was produced to start formation of the charge transport layer. When the formation of the charge injection blocking layer was started, the set variable ranges of capacities of the matching variable condenser 102 and the tuning variable condenser 103 were changed to the variable ranges to be applied during formation of the charge transport layer, and phase matching goal conditions and impedance matching goal conditions were set to the conditions for the charge transport layer shown in Table 8. The specific method for adjusting the impedance during formation of the charge transport layer was similar to that of Example 1.

After the charge transport layer was formed in this way, the flow rate of gas was first changed continuously in 5 minutes without stopping the discharge and then the power was changed in 5 minutes, so that the conditions were changed to those for formation of the next layer, namely the charge generation layer. At this time, the variable ranges of capacities of the matching variable condenser 102 and the tuning variable condenser 103, the phase matching goal condition and the impedance matching goal condition were continuously changed, so that the set values thereof were changed to the set values for the charge generation layer before the formation of the charge generation layer was started. Thereafter, the charge generation layer and then the surface layer were similarly formed while changing the variable ranges of capacities of the matching variable condenser 102 and the tuning variable condenser 103, the phase matching goal condition and the impedance matching goal condition to form the electrophotographic photosensitive member. Furthermore, after the charge generation layer was formed, the flow rate of gas, the power, the pressure, the variable ranges of capacities of the matching variable condenser 102 and the tuning variable condenser 103, the phase matching goal condition and the impedance matching goal condition were changed in 15 minutes without stopping the discharge to form the next layer, namely the surface layer.

In this way, ten lots of electrophotographic photosensitive members (total 120 members) each constituted of a charge transport layer, a charge generation layer and a surface layer were fabricated. The electrophotographic photosensitive member was formed stably in every lot.

Comparison Example 3

Ten lots of electrophotographic photosensitive members (total 120 members) each constituted of a charge transport layer, a charge generation layer and a surface layer were fabricated in the same manner as Example 3 under the conditions shown in Table 7 except that the variable ranges of capacities of the matching variable condenser 102 and the tuning variable condenser 103 were not set, and the phase matching goal condition and the impedance matching goal condition were fixed at 5% for all the layers. As a result, the capacities of the matching variable condenser 102 and the tuning variable condenser 103 were temporarily deviated considerably from stable points to destabilize the discharge during formation of the electrophotographic photosensitive member in three lots.

The a-Si photosensitive members fabricated in this way in Example 3 and Comparison example 3 were installed in a copier (NP-6030, manufactured by Canon Inc.) modified for proper testing to evaluate the properties of the photosensitive members. Evaluations were made for four items, namely "unevenness of image density," "photomemory," "variation of properties" and "image defect" using the specific evaluation methods similar to those of Example 1.

Results of evaluation are shown in Table 9. In Table 9, the evaluation was made with reference to the evaluation results of Comparison Example 3.

The electrophotographic photosensitive member fabricated in Example 3 showed satisfactory results in all the evaluation items to demonstrate the effect of the present invention.

Table 9

|  | Unevenness of Image Density | Photomemory | Variation of properties | Image Defect |
|---|---|---|---|---|
| Example 3 | AA - A | AA - A | AA | AA - A |

Example 4

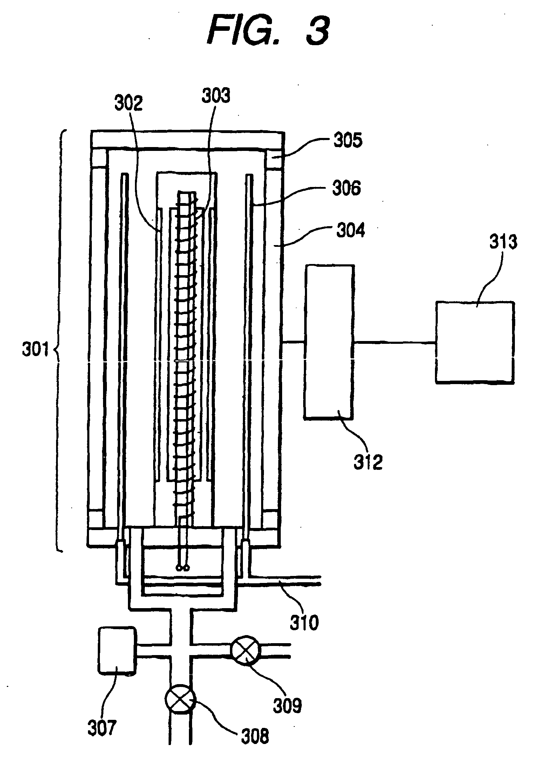

Using the plasma processing apparatus for formation of electrophotographic photosensitive members shown in FIG. 3, an electrophotographic photosensitive member was first formed under the conditions shown in Table 10, and the formed electrophotographic photosensitive member was then taken out of a reactor container, followed by cleaning the reactor container under the conditions shown in Table 12 with a dummy substrate placed in the reactor container. The plasma processing apparatus for formation of electrophotographic photosensitive members as shown in FIG. 3 has the following configuration.

Cylindrical substrates 302, a substrate supporter 303 containing a heater for heating substrates, and a raw material gas introduction pipe 306 are placed in a reactor container 301, and a high frequency matching box 312 connected to an RF power supply 313 capable of outputting a high frequency power of 13.56 MHz is connected to a cathode 304 constituting a part of the reactor container 301. The cathode 304 is insulated from a ground potential by an insulator 305, and is kept at a ground potential through the substrate support 303, thus making it possible to apply an RF voltage between itself and the cylindrical substrate 302 also serving as an anode. The matching box 312 has an inner configuration identical to that shown in FIG. 1, and the matching variable condenser 102 has a capacity variable in the range of from 50 pF to 1,000 pF while the tuning variable condenser 103 has a capacity variable in the range of from 5 pF to 250 pF.

The reactor container 301 is connected to an exhaust system (not shown) via an exhaust valve 308, and gas in the reactor container 301 can be exhausted to reduce the pressure therein by opening the exhaust valve 308. In addition, reference numeral 309 in FIG. 3 denotes a leak valve, and by opening the leak valve 309, a leak gas such as air, nitrogen gas, Ar gas, He gas or the like can be introduced into the reactor container 301 to release the reactor container 301 under reduced pressure to the atmosphere. Helium gas was used as a leak gas in this Example.

The raw material gas is introduced into the reactor container 301 from the raw material gas introduction pipe 306 connected to raw material gas pipeline 310, and the pressure in the reactor container can be detected by a pressure gauge 307.

Using this apparatus, the proper impedance variable ranges for the matching variable condenser 102 and the tuning variable condenser 103 were first determined in accordance with the following procedure.

First, the cylindrical substrate 302 is placed in the reactor container 301, and an exhaust system (not shown) was caused to exhaust gas in the reactor container 301 by opening the exhaust valve 308. Subsequently, 650 ml/min (normal) of Ar gas was supplied to the reactor container 301 from the raw material gas introduction pipe 306, the opening of the exhaust valve 308 was adjusted to keep the pressure in the reactor container 501 at 85 Pa, and the cylindrical substrate 302 was heated by the heater for heating substrates contained in the substrate support 303 while control was performed so that the temperature of the cylindrical substrate was kept at 260°C and this state was maintained for 1.5 hours.

Then, the supply of Ar gas was stopped, and gas in the reactor container 301 was exhausted by the exhaust system (not shown), followed by introducing a raw material gas for use in formation of the charge injection blocking layer shown in Table 10 via the raw material introduction pipe 306. After it was checked that the flow rate of raw material gas reached a predetermined flow rate, and the pressure in the reactor container 301 was stabilized, the output of the RF power supply 303 was set to a value equivalent to 20% of the condition for the charge injection blocking layer as shown in Table 10. In this state, the capacity of the matching variable condenser 102 in the matching box 312 was adjusted so that the difference between the output voltage from the impedance detector 108 and a reference voltage was reduced. The reference voltage was set to the value of output voltage from the impedance detector 108 with the impedance at the high frequency power input point of the matching box 312 on the load side being considered as 50 Ω. At the same time, the capacity of the tuning variable condenser 103 in the matching box 312 was adjusted so that the difference between the output voltage from the phase detector 107 and a reference voltage was reduced. The reference voltage was set to the value of output voltage from the phase detector 107 with the phase difference between the incident voltage at the high frequency power input point of the matching box 312 on the load side and the reflected voltage thereof being considered as 0 degree.

After the capacities of the matching variable condenser 102 and the tuning variable condenser 103 were adjusted so that the difference between the output voltage from the impedance detector 108 and the reference voltage, and the difference between the output voltage from the phase detector 107 and the reference voltage were minimized in this way, the output of the RF power supply 313 was increased to the value for the charge injection blocking layer shown in Table 10 to produce a discharge, and the capacities of respective variable condensers at the time when the discharge was produced were determined. Subsequently, the charge injection blocking layer was formed. When the formation of the charge injection blocking layer was started, the capacities of the matching variable condenser 102 and the tuning variable condenser 103 were adjusted again so that the absolute value of impedance at the input point of the matching box 312, and the phase difference between the incident voltage and the reflected voltage are minimized. This adjustment was continuously carried out during the formation of the charge injection blocking layer to determine the variation ranges of capacities of the matching variable condenser 102 and the tuning variable condenser 103 during the formation of the charge injection blocking layer.

When the formation of the charge injection blocking layer was completed, the output of high frequency voltage was stopped, plasma processing conditions such as the type and flow rate of gas and the pressure were changed to the conditions for formation of the photoconductive layer shown in Table 10, and the variation ranges of capacities of the matching variable condenser 102 and the tuning variable condenser 103 at the time of producing a discharge, and the variation ranges of capacities of the matching variable condenser 102 and the tuning variable condenser 103 during formation of the photoconductive layer were determined in the same manner as that at the time of forming the charge injection blocking layer.

For the surface layer, the variation ranges of capacities of the matching variable condenser 102 and the tuning variable condenser 103 during production of a discharge, and the variation ranges of capacities of the matching variable condenser 102 and the tuning variable condenser 103 during formation of the surface layer were similarly determined.

This experiment was repeated five times to determine the variation ranges of capacities of the matching variable condenser 102 and the tuning variable condenser 103 during production of the discharge for the charge injection blocking layer, photoconductive layer and surface layer, and the variation ranges of capacities of the matching variable condenser 102 and the tuning variable condenser 103 during formation of those layers, and based on the results thereof, the variable ranges of capacities of the matching variable condenser 102 and the tuning variable condenser 103 during production of the discharge for the charge injection blocking layer, photoconductive layer and surface layer, and the variable ranges of capacities of the matching variable condenser 102 and the tuning variable condenser 103 during formation of those layers were determined in the same manner as Example 1.

Then, phase matching goal conditions and impedance matching goal conditions were determined in the same manner as Example 2. At this time, the procedure for operating the plasma processing apparatus for formation of electrophotographic photosensitive members can be the same as the procedure used for determining the variable ranges of capacities of the matching variable condenser 102 and the tuning variable condenser 103.

The variable ranges of capacities of the matching variable condenser 102 and the tuning variable condenser 103, the phase matching goal conditions and the impedance matching goal conditions determined in this way are shown in Table 11.

After the variable ranges of capacities of the matching variable condenser 102 and the tuning variable condenser 103, the phase matching goal conditions and the impedance matching goal conditions were determined in this way, a-Si based photosensitive members were formed under the conditions shown in Tables 10 and 11. When the formation of the a-Si based photosensitive member was completed, the reactor container 301 was adequately purged with a helium gas, and thereafter the leak valve 309 was opened with the exhaust valve 308 closed to introduce He into the reactor container 301, thereby releasing the reactor container 301 to the atmosphere. Subsequently, the cylindrical substrate on which a deposition film was formed, namely the a-Si based photosensitive member was taken out from the reactor container 301, and a dummy cylinder was placed therein instead.

Then, the exhaust valve 308 was opened to exhaust gas in the reactor container 301 by the exhaust system (not shown), followed by supplying gases for cleaning processing as shown in Table 12 to the reactor container 301 through the raw material gas introduction pipe 306, adjusting the opening of the exhaust valve 308 to adjust the pressure in the reactor container 301.

When the adjustment of pressure was completed, the variable ranges of capacities of the matching variable condenser 102 and the tuning variable condenser 103, the phase matching goal conditions and the impedance matching goal conditions were determined in the same way as done in the case of formation of photosensitive members 13. The conditions determined are shown in Table 13.

After the condition for formation of the a-Si based photosensitive member and the condition for cleaning the reactor container were determined in this way, these conditions were used to carry out formation of the a-Si based photosensitive member and subsequent cleaning of the reactor container was carried out in five cycles.

Table 10

|  | Charge Injection Blocking Layer | Photoconductive Layer | Surface Layer |
|---|---|---|---|
| Type of Gas and Flow Rate $SiH_4$ (ml/min (normal)) $H_2$ (ml/min (normal)) $B_2H_6$ (ppm) Relative to $SiH_4$ $CH_4$ (ml/min (normal)) NO (ml/min (normal)) | 300 300 3,000 15 | 100 600 0.5 | 10 600 |
| Substrate Temperature (°C) | 260 | 260 | 260 |
| Internal Pressure (Pa) | 40 | 40 | 55 |
| High Frequency Power (W) | 300 | 600 | 200 |
| Film Thickness (μm) | 3 | 27 | 0.5 |

Table 11

|  | Starting Discharge | Forming of BL | Starting Discharge | Forming of PCL | Starting Discharge | Forming of SL |
|---|---|---|---|---|---|---|
| MC Capacity Variation Range (pF) | 360 - 440 | 345 - 565 | 360 - 440 | 355 - 383 | 600 -640 | 610 - 690 |
| TC Capacity variation Range (pF) | 94 - 110 | as - 104 | 94 - 110 | 88 - 106 | 110- 126 | 104 - 136 |
| Phase Matching Goal Condition |  | 5% |  | 4% |  | 6% |
| Impedance Matching Goal Condition |  | 4% |  | 4% |  | 6% |
| MC: Matching Condenser, TC: Tuning Condenser BL: Charge Injection Blocking Layer, PCL, Photoconductive Layer, SL: Surface Layers | | | | | | |

Table 12

|  | Cleaning |
|---|---|
| Type of Gas and Flow Rate CIF$_3$ (ml/min (normal)) Ar (ml/min (normal)) | 200 1,600 |
| Internal Pressure (Pa) | 80 |
| High Frequency Power (W) | 1,200 |
| Time (minutes) | 210 |

Table 13

|  | Starting of Cleaning | Start to 60 min. | 60 min. to 120 min. | 120 min. to 180 min. | 180 min. to 210 min. |
|---|---|---|---|---|---|
| MC Capacity Variation Range (pF) | 360 - 400 | 325 - 370 | 325 - 365 | 320 - 365 | 300 - 340 |
| TC Capacity Variation Range (pF) | 130 - 145 | 122 - 138 | 120 - 138 | 118 - 136 | 110 - 126 |
| Phase Matching Goal Condition |  | 5% | 5% | 4% | 3% |
| Impedance Matching Goal Condition |  | 4% | 4% | 4% | 3% |
| MC: Matching Condenser, TC: Tuning Condenser | | | | | |

Comparison Example 4

In the same manner as Example 4, a-Si based photosensitive members were formed under the conditions shown in Table 10 except that the variable ranges of capacities of the matching variable condenser 102 and the tuning variable condenser 103 were not set, and the phase matching goal condition and the impedance matching goal condition were always fixed at 6%. Furthermore, when the phase matching goal condition and impedance matching goal condition were set at 4% as in the case of PCL conditions in Example 4, the capacities of the matching variable condenser 102 and the tuning variable condenser 103 were changed during formation of the surface layer.

Then, cleaning of the reactor container was carried out in the same manner as Example 4 except that the variable ranges of capacities of the matching variable condenser 102 and the tuning variable condenser 103 were not set, and that the phase matching goal condition was fixed at 5% throughout the cleaning, and the impedance matching goal condition was fixed at 4% throughout the cleaning.

In this way, formation of the a-Si based photosensitive member and subsequent cleaning of the reactor container were carried out in five cycles.

The a-Si based photosensitive members fabricated in this way in Example 4 and Comparison Example 4 were installed in a copier (NP-6750, manufactured by Canon Inc.) modified for proper testing to evaluate the properties of the photosensitive members. Evaluations were made for four items, namely "unevenness of image density," "photomemory," "variation of properties" and "image defect" using the evaluation methods similar to those of Example 1.

Results of evaluation are shown in Table 14. In Table 14, the evaluation was made with reference to the evaluation results of Comparison Example 4.

The electrophotographic photosensitive member fabricated in Example 4 showed satisfactory results in all the evaluation items to demonstrate the effect of the present invention.

In addition, in Example 4, the reactor container was adequately cleaned with no residues existing therein in any cycles, while in Comparison Example 4, polysilane remained partially in the reactor container in two of five cycles and therefore it was necessary to clean the reactor container again.

Table 14

|  | Unevenness of Image Density | Photomemory | Variation of Properties | Image Defect |
|---|---|---|---|---|
| Example 4 | AA - A | AA - A | AA | AA |

Example 5

Using the plasma processing apparatus shown in FIGS. 6A and 6B and a matching box having the configuration shown in FIG. 1, ten lots of a-Si based photosensitive members (total 60 members) each constituted of a charge injection blocking layer, a photoconductive layer and a surface layer were fabricated on a cylindrical aluminum cylinder 605 with a diameter of 80 mm and a length of 358 mm under the conditions shown in Table 15, with oscillation frequencies of high frequency power supplies 603 and 615 each fixed at 100 MHz. In Table 15, the high frequency power refers to effective power obtained by subtracting a reflected power from an incident power. High frequency electrodes 602 and 614 were SUS cylinders with diameters of 20 mm, of which outer faces were covered with alumina pipes with inner diameters of 21 mm and outer diameters of 24 mm. The alumina pipe was subjected to blast processing so that its surface roughness level was 20 $\mu$m in Rz with reference length of 2.5 mm. Six cylindrical substrates 605 were arranged at equal intervals on the same circumference.

In addition, as matching variable condensers 102a and 102b, those having capacities variable within the range of from 50 pF to 1,000 pF inclusive were used, and as tuning variable condensers 103a and 103b, those having capacities variable within the range of from 5 pF to 250 pF inclusive. High frequency power supplies 603 and 615, of which output impedances were 50 $\Omega$, were electrically connected to matching boxes 604 and 616, respectively, via a coaxial cable having a characteristic impedance of 50 $\Omega$.

By plasma processing apparatus having a configuration described above, the impedance variable ranges for the matching variable condenser 102a and 102b and the tuning variable condensers 103a and 103b were first determined according to the following procedure.

First, the cylindrical substrate 605 was placed on a rotation shaft 608 in the reactor container 601. Thereafter, gas in the reactor container 601 was exhausted through an exhaust pipe 611 by an exhaust system (not shown). Subsequently, the cylindrical substrate 605 was rotated with a motor (not shown) at a speed of 10 rpm via the rotation shaft 608, and 500 ml/min (normal) of Ar gas was supplied to the reactor container 601 through a raw material gas supply pipe 612 while the cylindrical substrate 605 was heated by a heating element 607 with control being performed so that the cylindrical substrate 605 was kept at a temperature of 250°C and this state was maintained for two hours.

Then, the supply of Ar gas was stopped, and gas in the reactor container 601 was exhausted through the exhaust pipe 611 by the exhaust system (not shown), followed by introducing a raw material gas for use in formation of the charge injection blocking layer shown in Table 15 through the raw material gas supply pipe 612. After it was checked that the flow rate of raw material gas reached a predetermined flow rate, and the pressure in the reactor container 601 was stabilized, the outputs of the high frequency power supplies 603 and 615 were set to a value equivalent to 20% of the condition for the charge injection blocking layer shown in Table 15. In this state, the capacities of the matching variable condensers 102a and 102b in the matching boxes 604 and 616 were adjusted so that differences between output voltages from the impedance detectors 108a and 108b and a reference voltage were reduced. The reference voltage was set to the values of output voltages from the impedance detectors 108a and 108b with the impedance at the high frequency power input point of the matching boxes 604 and 616 on the load side being considered as 50 $\Omega$. At the same time, the capacities of the tuning variable condensers 103a and 103b in the matching boxes 604 and 616 were adjusted so that differences between output voltages from the phase detectors 107a and 107b and reference voltages were reduced. The reference voltage was set to values of output voltages from the phase detectors 107a and 107b with phase differences between incident voltages at the high frequency power input points of the matching boxes 604 and 616 on the load side and reflected voltages thereof being considered as 0 degree.

After the capacities of the matching variable condensers 102a and 102b and the tuning variable condensers 103a and 103b were adjusted so that the differences between the output voltages from the impedance detectors 108a and 108b and the reference voltage, and the differences between the output voltages from the phase detectors 107a and 107b and the reference voltage were minimized in this way, the outputs of the high frequency power supplies 603 and 615 were increased to the values for the charge injection blocking layer conditions shown in Table 15 to produce a discharge, and the capacities of respective variable condensers at the time when the discharge was produced were determined. Subsequently, the charge injection blocking layer was formed. After the formation of the charge injection blocking layer was started, the capacities of the matching variable condensers 102a and 102b and the tuning variable condensers 103a and 103b were adjusted again so that the absolute values of impedance at the input points of the matching boxes 604 and 616, and the phase difference between the incident voltage and the reflected voltage were minimized. This adjustment was carried out at two-minute intervals during the formation of the charge injection blocking layer to determine the variation ranges of capacities of the matching variable condensers 102a and 102b and the tuning variable condensers 103a and 103b during the formation of the charge injection blocking layer.

After the formation of the charge injection blocking layer was completed, the output of high frequency voltage was stopped, plasma processing conditions such as the type and flow rate of gas and the pressure were changed to the conditions for formation of the photoconductive layer shown in Table 15, and the variation ranges of capacities of the matching variable condensers 102a and 102b and the tuning variable condensers 103a and 103b during production of a discharge, and the variation ranges of capacities of the matching variable condensers 102a and 102b and the tuning variable condenser 103a and 103b during formation of the photoconductive layer were determined in the same way as done in the case of formation of the charge injection blocking layer.

For the surface layer, the variation ranges of capacities of the matching variable condensers 102a and 102b and the tuning variable condensers 103a and 103b during production of a discharge, and the variation ranges of capacities of the matching variable condensers 102a and 102b and the tuning variable condensers 103a and 103b during formation of the surface layer were similarly determined.

This experiment was repeated ten times to determine the variation ranges of capacities of the matching variable condensers 102a and 102b and the tuning variable condensers 103a and 103b during production of the discharge for the charge injection blocking layer, photoconductive layer and surface layer, and the variation ranges of capacities of the matching variable condensers 102a and 102b and the tuning variable condensers 103a and 103b during formation of those layers.

Based on the results, the variation ranges of capacities of the matching variable condensers 102a and 102b and the tuning variable condensers 103a and 103b at the time of starting production of a discharge for the charge injection blocking layer, during formation of the charge injection blocking layer, at the time of starting production of a discharge for the photoconductive layer, during formation of the photoconductive layer, at the time of starting production of a discharge for the surface layer and during formation of the surface layer were determined so as to meet the two conditions of : (1) the center of the capacity variable range is the center of the capacity variation range; and (2) the capacity variable range is twice as wide as the capacity variation range.

Table 15

| | Charge Injection Blocking Layer | Photoconductive Layer | Surface Layer |
|---|---|---|---|
| Type of Gas and Flow Rate | | | |
| $SiH_4$ (ml/min (normal)) | 300 | 600 | 5 |
| $H_2$ (ml/min (normal)) | 300 | 200 | |
| $B_2H_6$ (ppm) | 1.000 | 1.8 | |
| Relative to $SiH_4$ | | | |
| $CH_4$ (ml/min (normal)) | | | 55 |
| NO (ml/min (normal)) | 15 | | |
| Substrate (°C) Temperature | 270 | 270 | 250 |
| Internal Pressure (Pa) | 2.0 | 1.0 | 1.5 |
| High Frequency Power (W) (High Frequency Power Supply 404) | 200 | 500 | 150 |
| High Frequency Power (W) Film (High Frequency Power Supply 415) | 600 | 1,500 | 450 |
| Thickness ($\mu$m) | 3 | 27 | 0.5 |

After the variable ranges of capacities of the matching variable condensers 102a and 102b and the tuning variable condensers 103a and 103b were determined in this way, ten lots of electrophotographic photosensitive members were fabricated in the following manner under the conditions shown in Table 15.

First, the cylindrical substrate 605 was placed on the rotation shaft 608 in the reactor container 601. Thereafter, gas in the reactor container 601 was exhausted via the exhaust pipe 611 by the exhaust system (not shown). Subsequently, the cylindrical substrate 605 was rotated with the motor (not shown) at a speed of 10 rpm via the rotation shaft 608, and 500 ml/min (normal) of Ar gas was supplied to the reactor container 601 through the raw material gas supply pipe 612 while the cylindrical substrate 605 was heated by the heating element 607 with control being performed so that the cylindrical substrate 605 was kept at a temperature of 250°C and this state was maintained for two hours.

Then, the supply of Ar gas was stopped, and gas in the reactor container 601 was exhausted through the exhaust pipe 611 by the exhaust system (not shown), followed by introducing a raw material gas for use in formation of the charge injection blocking layer shown in Table 15 through the raw material gas supply pipe 612. After it was checked that the flow rate of raw material gas reached a predetermined flow rate, and the pressure in the reactor container 601 was stabilized, the outputs of the high frequency power supplies 603 and 615 were set to a value equivalent to 20% of the condition for the charge injection blocking layer shown in Table 15.

Furthermore, the variable ranges of capacities at the starting production of a discharge for the charge injection blocking layer, during formation of the charge injection blocking layer, during formation of photoconductive layer and during formation of the surface layer are previously inputted and set in impedance/phase control units 109a and 109b based on the results of experiments for determining variable ranges of capacities, and a capacity variable range indicating signal is inputted therein to select desired variable ranges of capacities.

In this state, the capacity variable range indicating signal is first inputted in the impedance/phase control units 109a and 109b to select the variable range of capacity at the time of starting production of a discharge for the charge injection blocking layer, followed by starting the automatic control of impedance. Specifically, at the inlets of matching circuits 101a and 101b, high frequency currents are detected by current detection elements 105a and 105b, and high frequency voltages are detected by voltage detection elements 106a and 106b. The outputs of the current detection elements 105a and 105b, and the voltage detection elements 106a and 106b are inputted to phase difference detectors 107a and 107b and impedance detectors 108a and 108b in control systems 100a and 100b, respectively. The phase difference detectors 107a and 107b detect phases of impedances at the inlets of the matching circuits 101a and 101b, and output voltages consistent with the phase of impedance to the impedance/phase control units 109a and 109b. The impedance/phase control units 109a and 109b control the impedances of the tuning variable condensers 103a and 103b based on the voltages inputted from the phase difference detectors 107a and 107b within a predetermined variable range at the time of starting production of a discharge for the charge injection blocking layer. That is, the voltages inputted from the phase difference detectors 107a and 107b are compared with reference voltages, voltages consistent with the differences therebetween are supplied to motors 110a and 110b for driving the tuning variable condensers 103a and 103b, and adjustments are made so that differences between the voltages inputted from the phase difference detectors 17a and 17b and the reference voltage are reduced. At this time, when the impedances of the tuning variable condensers 103a and 103b reach maximum or minimum values in the variable range at the time of starting production of a discharge for the charge injection blocking layer, the supply of voltages to the motors 110a and 110b is immediately stopped, and control is performed so that the variable range of capacities is not exceeded. The reference voltage is set to the values of output voltages from the phase detectors 107a and 107b with the phase difference between the incident voltage at high frequency power input points of the matching boxes 604 and 616 on the load sides and the reflected voltages thereof being considered as 0 degree.

On the other hand, the impedance detectors 108a and 108b detect the absolute values of impedance at the inlets of the matching circuits 101a and 101b, and output voltages consistent with the absolute values of impedance to the impedance/phase control units 109a and 109b. The impedance/phase control units 109a and 109b control the impedances of the matching variable condensers 102a and 102b based on the voltages inputted from the impedance detectors 108a and 108b within a predetermined variable range at the time of starting production of a discharge for the charge injection blocking layer. That is, the voltages inputted from the impedance detectors 108a and 108b are compared with the reference voltage, voltages consistent with the differences therebetween are supplied to motors 112a and 112b for driving the matching variable condensers 102a and 102b, and adjustments are made so that differences between the voltages inputted from the impedance detectors 108a and 108b and the reference voltage is reduced. At this time, when the impedances of the matching variable condensers 102a and 102b reach maximum or minimum values in the variable range, the supply of voltages to the motors 112a and 112b is immediately stopped, and automatic control is performed so that the variable range of capacities is not exceeded. The reference voltage is set to values of output voltages from the impedance detectors 108a and 108b with impedances at the high frequency power input points of the matching boxes 604 and 616 on the load sides being considered as 50 Ω.

With the impedances of the matching variable condensers 102a and 102b and the tuning variable condensers 103a and 103b being adjusted with automatic control in this way, the outputs of the high frequency power supplies 603 and 615 were increased to the values for the charge injection blocking layer shown in Table 15, thereby producing a discharge to start formation of the charge injection blocking layer. After the formation of the charge injection blocking layer was started, capacity variable range indicating signals were inputted to the impedance/phase control units 109a and 109b, whereby variable ranges of capacities to be applied during formation of the charge injection blocking layer were selected, and the variable ranges of capacities of the matching variable condensers 102a and 102b and the tuning variable condensers 103a and 103b were changed to the ranges to be applied during formation of the charge injection blocking layer. The impedance/phase control units 109a and 109b adjust the capacities of the tuning variable condensers 103a and 103b within the changed capacity variable ranges. When the capacities of the tuning variable condensers 103a and 103b reach maximum or minimum values in the variable range, or differences between voltages inputted from the phase detectors 107a and 107b and a reference voltage reach a level equivalent to the matching goal condition or lower, the supply of voltages to the motors 110a and 110b is stopped. The reference voltage is set to values of output voltages from the phase detectors 107a and 107b with the phase difference between the incident voltage at high frequency power input points of the matching boxes 604 and 616 on the load sides and the reflected voltages being considered as 0 degree. The matching goal condition is set so that the differences between the voltages inputted from the phase detectors 107a and 107b and the reference voltage equal 6% or smaller of the reference voltage.

At the same time, the impedance/phase control units 109a and 109b adjust the capacities of the matching variable condensers 102a and 102b within the changed capacity variable range. When the capacities of the matching variable condensers 102a and 102b reach maximum or minimum values in the variable range, or differences between voltages inputted from the impedance detectors 108a and 108b and a reference voltage reach a level equivalent to the matching goal condition or lower, the supply of voltages to the motors 112a and 112b is stopped. The reference voltage is set to values of output voltages from the impedance detectors 108a and 108b with impedances at the high frequency power input points of the matching boxes 604 and 616 on the load sides being considered as 50 $\Omega$. The matching goal condition is set so that the differences between the voltages inputted from the impedance detectors 108a and 108b and the reference voltage equal 6% or smaller of the reference voltage.

After the charge injection blocking layer was formed in this way, the output of high frequency powers was stopped, plasma processing conditions such as the type and flow rate of gas and the pressure were set to the conditions for formation of the photoconductive layer shown in Table 15, and capacity variable range indicating signals were inputted to the impedance/phase control units 109a and 109b to select a capacity variable range to be applied at the time of starting production of a discharge for the photoconductive layer, followed by producing a discharge in the same manner as the case of the charge injection blocking layer to form the photoconductive layer.

After the formation of the photoconductive layer was completed, the output of high frequency powers was stopped, plasma processing conditions such as the type and flow rate of gas and the pressure were set to the conditions for formation of the surface layer shown in Table 15, and capacity variable range indicating signals were inputted to the impedance/phase control units 109a and 109b to select a capacity variable range to be applied at the time of starting production of a discharge for the surface layer, followed by producing a discharge in the same manner as the formation of the charge injection blocking layer to form the surface layer.

In this way, ten lots of electrophotographic photosensitive members (total 60 members) each constituted of a charge injection blocking layer, a photoconductive layer and a surface layer were fabricated. The electrophotographic photosensitive member was formed with stability in every lot. Comparison Example 5

Ten lots of electrophotographic photosensitive members (total 60 members) each constituted of a charge injection blocking layer, a photoconductive layer and a surface layer were fabricated in the same manner as Example 5 under the conditions shown in Table 15 except that the variable ranges of capacities of the matching variable condensers 102a and 102b and the tuning variable condensers 103a and 103b were not set. As a result, the capacities of the matching variable condensers 102a and 102b and the tuning variable condensers 103a and 103b were temporarily deviated considerably from stable points to destabilize the discharge during formation of the electrophotographic photosensitive member in two lots.

The a-Si photosensitive members fabricated in this way in Example 5 and Comparison Example 5 were installed in a copier (NP-6750, manufactured by Canon Inc., modified for proper testing) to make evaluations for four items, namely "unevenness of image density," "photomemory," "variation of properties" and "image defect" using the evaluation methods similar to those of Example 1.

Results of evaluation are shown in Table 16. The evaluation was made with reference to the evaluation results of Comparison Example 5.

The electrophotographic photosensitive member fabricated in Example 5 showed satisfactory results in all the evaluation items. In addition, the electrophotographic image formed using the electrophotographic photosensitive member fabricated in Example 5 had no image smears, etc., and was thus quite satisfactory.

Table 16

| | Unevenness of Image Density | Photomemory | Variation of Properties | Image Defect |
|---|---|---|---|---|
| Example 5 | A | A | A | AA - A |

(Example 6)

Using the plasma processing apparatus and matching boxes used in Example 5, matching goal conditions during formation of the charge injection blocking layer, photoconductive layer and surface layer were determined under the conditions shown in Table 15 in accordance with the following procedure, with the oscillation frequencies of high frequency power supplies 603 and 615 being fixed at 100 MHz.

First, formation of the charge injection blocking layer was started in accordance with a procedure similar to the procedure used when the impedance variable range was determined in Example 5. After formation of the charge injection blocking layer was started, the capacities of the matching variable condensers 102a and 102b and tuning variable condensers 103a and 103b were changed within 10% or less of power reflectivity while observing the incident power and reflected power at the high frequency power input points of the matching boxes 604 and 616, and thereby the maximum value of differences between voltages outputted from the phase detectors 107a and 107b and a phase reference voltage, and the maximum value of differences between voltages outputted from impedance detectors 108a and 108b and an impedance reference voltage were determined. Furthermore, the power reflectivity is a ratio of reflected power to the incident power. In addition, the phase reference voltage was set to values of output voltages from the phase detectors 107a and 107b with the phase difference between the incident voltage at high frequency power input points of the matching boxes 604 and 616 on the load sides and the reflected voltages being considered as 0 degree. In addition, the impedance reference voltage was set to values of output voltages from the impedance detectors 108a and 108b with impedances at the high frequency power input points of the matching boxes 604 and 616 on the load sides being considered as 50 Ω.

The maximum value of differences between voltages outputted from the phase detectors 107a and 107b and a phase reference voltage, and the maximum value of differences between voltages outputted from the impedance detectors 108a and 108b and an impedance reference voltage were determined at intervals of two minutes during formation of the charge injection blocking layer, and the largest maximum value among them was used to determine the following phase matching goal condition and impedance matching goal condition.

**Phase matching goal condition (%) = {(maximum value of differences between output voltages of phase detectors 107a and 107b and phase reference voltage)/(phase reference voltage)} × 100**

**Impedance matching goal condition (%) = {(maximum value of differences between output voltages of impedance detectors 108a and 108b and impedance reference voltage)/(impedance reference voltage)} × 100**

Matching goal conditions to be applied during formation of the photoconductive layer and during formation of the surface layer were similarly determined. The resulting matching goal conditions for respective layers are shown in Table 17.

Table 17

|  | Charge Injection Blocking Layer | Photoconductive Layer | Surface Layer |
| --- | --- | --- | --- |
| Phase Matching Goal Condition | 5% | 3% | 6% |
| Impedance Matching Goal Condition | 4% | 3% | 6% |

After the matching goal conditions to be applied during formation of respective layers were determined in this way, ten lots of electrophotographic photosensitive members (total 60 members) each constituted of a charge injection blocking layer, a photoconductive layer and a surface layer were fabricated in the same manner as Example 5 under the conditions shown in Table 15. Furthermore, in this Example, the matching goal conditions were set to the values shown in Table 17 for each of the charge injection blocking layer, photoconductive layer and surface layer. That is, the matching goal conditions were changed during formation of the electrophotographic photosensitive member.

As a result, the electrophotographic photosensitive member was formed with stability in every lot.

Comparison Example 6

Ten lots of electrophotographic photosensitive members (total 60 members) each constituted of a charge injection blocking layer, a photoconductive layer and a surface layer were fabricated in the same manner as Comparison Example 5 under the conditions shown in Table 15 except that the phase matching goal condition and the impedance matching goal condition were fixed at 3% as in the case of the condition for the photoconductive layer in Example 6 in all of the charge injection blocking layer, photoconductive layer and surface layer.

As a result, the capacities of the matching variable condensers 102a and 102b and the tuning variable condensers 103a and 103b were always fluctuated during formation of the surface layer, thus making it impossible to form the electrophotographic photosensitive member with stability in all lots.

For the a-Si photosensitive members fabricated in this way in Example 6 and Comparison Example 6, evaluations were made for four items, namely "unevenness of image density," "photomemory," "variation of properties" and "image defect" using the evaluation methods similar to those of Example 1.

Results of evaluation are shown in Table 18. The evaluation was made with reference to the evaluation results of Example 1.

The electrophotographic photosensitive member fabricated in Example 6 showed satisfactory results in all the evaluation items. In addition, the electrophotographic photosensitive member fabricated in Example 6 had better properties than the electrophotographic photosensitive member fabricated in Example 5. It has been shown from comparison with the results from Comparison Example 6 that this effect of Example 6 is due to not just the fact that the matching goal condition was narrowed compared to Example 5, but the fact that the impedance variable range was changed as plasma processing proceeded, and the matching goal condition was also changed as plasma processing proceeded.

Table 18

| | Unevenness of Image Density | Photomemory | Variation of Properties | Image Defect |
|---|---|---|---|---|
| Example 6 | AA - A | A | AA | AA - A |
| Comparative Example 6 | C | C | C | C |

Example 7

The plasma processing apparatus shown in FIGS. 7A and 7B was used to form a-Si based photosensitive members under the conditions shown in Table 19. An aluminum cylinder with a diameter of 30 mm and a length of 358 mm was used as a cylindrical substrate 705. A raw material gas supply pipe 710 was an alumina pipe with an inner diameter of 10 mm and an outer diameter of 13 mm, had its ends sealed, and was capable of supplying a raw material gas from a gas blast nozzle with a diameter of 1.2 mm provided on the pipe. The raw material gas supply pipe 710 had its surface subjected to blast processing so that its surface roughness level was 20 $\mu$m in Rz with standard length of 2.5 mm.

A high frequency power supply 711 had a frequency of 120 MHz and an output impedance of 50 $\Omega$. The high frequency power supply 711 and a matching box 712 were electrically connected together via a coaxial cable having a characteristic impedance of 50 $\Omega$. In addition, a high frequency power supply 713 had a frequency of 70 MHz and an output impedance of 50 $\Omega$. The high frequency power supply 713 and a matching box 714 were electrically connected together via a coaxial cable having a characteristic impedance of 50 $\Omega$.

A high frequency electrode 702 was an SUS cylinder with a diameter of 20 mm. In addition, an alumina cylindrical dielectric wall 703 constituting a part of a reactor container 701 had its inner surface subjected to blast processing so that the surface roughness level was 20 $\mu$m in Rz with standard length of 2.5 mm.

In addition, specific configurations of the matching boxes 712 and 714 are those shown in FIG. 1, but for discriminating between members in the matching box 712 and members in the matching box 714, the members in the matching box 712 will be given a symbol "a" and the members in the matching box 714 will be given a symbol "b" for convenience in the description below.

Matching variable condensers 102a and 102b had capacities variable in the range of from 50 pF to 1,000 pF inclusive, and tuning variable condensers 103a and 103b had capacities variable in the range of from 5 pF to 250 pF inclusive.

Using the plasma processing apparatus having the configuration described above, the impedance variable range was first determined in the same manner as Example 5 under the conditions shown in Table 19. Then, the matching goal condition was determined in the same manner as Example 6 under the conditions shown in Table 19. Furthermore, after the charge transport layer was formed, the flow rate of gas was first changed continuously in 5 minutes, and the power was then changed in 5 minutes without stopping production of a discharge to form the next layer, namely the charge generation layer. In addition, after the charge generation layer was formed, the flow rate of gas, the power and the pressure were continuously changed in 15 minutes without stopping production of a discharge to form the next layer, namely the surface layer. In this way, the impedance variable range and the matching goal condition were determined.

Table 19

|  | Charge Transport Layer | Charge Generation Layer | Surface Layer |
|---|---|---|---|
| Type and Flow Rate of Gas $SiH_4$ (ml/min (normal)) $H_2$ (ml/min (normal)) $B_2H_6$ (ppm) Relative to $SiH_4$ $CH_4$ (ml/min (normal)) | 300 450 $8 \rightarrow 1.5$ $300 \rightarrow 0$ | 200 800 1.5 | 15 200 |
| Substrate Temperature (°C) | 250 | 250 | 250 |
| Internal Pressure (Pa) | $7 \rightarrow 4$ | 4 | 3 |
| High Frequency Power (W) (High Frequency Power Supply 711) | 900 | 600 | 300 |
| High Frequency Power (w) (High Frequency Power Supply 713) | 300 | 200 | 100 |
| Film Thickness ($\mu$m) | 25 | 5 | 0.5 |

Table 20

|  | Starting of Discharge | Forming Charge Transport Layer | Change | Forming of Area Charge Generation Layer | Change Area | Forming of surface Layer |
|---|---|---|---|---|---|---|
| Phase matching Goal Condition |  | 4% | Continuously Changed | 5% | Continuously Changed | 7% |
| Impedance Matching Goal Condition |  | 4% | 4% | 4% | Continuously Changed | 6% |

Using the impedance variable range and the matching goal condition determined in this way, ten lots of electrophotographic photosensitive members were fabricated in accordance with the following general procedure under the conditions shown in Table 19.

First, a cylindrical aluminum cylinder 705 supported on a substrate holder 706 was placed on a rotation shaft 708 in the reactor container 701. Thereafter, gas in the reactor container 701 was exhausted through the exhaust pipe 709 by the exhaust system (not shown). Subsequently, the cylindrical aluminum cylinder 705 was rotated at the speed of 10 rpm with a motor (not shown) via the rotation shaft 708, and 500 ml/min (normal) of Ar gas was supplied to the reactor container 701 from a raw material gas supply pipe 510 while the cylindrical aluminum cylinder 705 was heated by a heating element 707 with control being performed so that its temperature was kept at 250°C and this state was maintained for two hours.

Then, the supply of Ar gas was stopped, and gas in the reactor container 701 was exhausted through the exhaust pipe 708 by the exhaust system (not shown), followed by introducing via the raw material gas supply pipe 710 a raw material gas for use in formation of the charge transport layer shown in Table 19. After it was checked that the flow rate of raw material gas reached a predetermined flow rate, and the pressure in the reactor container 701 was stabilized, the outputs of the high frequency power supplies 711 and 713 were set to a value equivalent to 20% of the condition for the charge transport layer shown in Table 19.

In this state, capacity variable range indicating signals were first inputted to the impedance/phase control units 109a and 109b to select the capacity variable range to be applied at the time of starting production of a discharge for the charge transport layer, and then automatic control of impedance was started. The specific control method was similar to that of Example 5.

The impedances of the matching variable condensers 102a and 102b and the tuning variable condensers 103a and 103b were adjusted in this way, and at the same time the outputs of the high frequency power supplies 711 and 713 were increased to the values of conditions for the charge transport layer shown in Table 19, whereby a discharge was produced to start formation of the charge transport layer. After the formation of the charge transport layer was started, capacity variable range indicating signals were inputted to the impedance/phase control units 109a and 109b, whereby the capacity valuable range to be applied during formation of the charge transport layer was determined, and the phase matching goal condition and impedance matching goal condition were set to predetermined conditions for the charge transport layer shown in Table 20. The specific method for adjusting impedances during formation of the charge transport layer was similar to that of Example 5.

After the formation of the charge transport layer was completed in this way, the flow rate of gas was first changed continuously in 5 minutes, and then the power was changed in 5 minutes without stopping the discharge, so that the conditions were changed to those for formation of the next layer, namely the charge generation layer. At this time, the variable ranges of capacities of the matching variable condensers 102a and 102b and the tuning variable condensers 103a and 103b, the phase matching goal condition and the impedance matching goal condition were continuously changed, so that the set values thereof were changed to the set values for the charge generation layer when the formation of the charge generation layer was started. Thereafter, the charge generation layer and then the surface layer were similarly formed while changing the variable ranges of capacities of the matching variable condensers 102a and 102b and the tuning variable condensers 103a and 103b, the phase matching goal condition and the impedance matching goal condition to form the electrophotographic photosensitive member. Furthermore, after the charge generation layer was formed, the flow rate of gas, the power, the pressure, the variable ranges of capacities of the matching variable condensers 102a and 102b and the tuning variable condensers 103a and 103b, the phase matching goal condition and the impedance matching goal condition were changed in 15 minutes to form the next layer, namely the surface layer without stopping the discharge.

In this way, ten lots of electrophotographic photosensitive members (total 120 members) each constituted of a charge transport layer, a charge generation layer and a surface layer were fabricated. The electrophotographic photosensitive member was formed stably in every lot.

Comparison Example 7

Ten lots of electrophotographic photosensitive members (total 120 members) each constituted of a charge transport layer, a charge generation layer and a surface layer were fabricated in the same manner as Example 7 under the conditions shown in Table 19 except that the variable ranges of capacities of the matching variable condensers 102a and 102b and the tuning variable condensers 103a and 103b were not set, and the phase matching goal condition and the impedance matching goal condition were fixed at 7% for all the layers. As a result, the capacities of the matching variable condensers 102a and 102b and the tuning variable condensers 103a and 103b were temporarily deviated considerably from stable points to destabilize the discharge during formation of the electrophotographic photosensitive member in five lots.

The a-Si based photosensitive members fabricated in this way in Example 7 and Comparison example 7 were installed in a copier (NP-6030, manufactured by Canon Inc., modified for proper testing) to evaluate the properties of the photosensitive members. Evaluations were made for four items, namely "unevenness of image density," "photomemory," "variation of properties" and "image defect."

Results of evaluation are shown in Table 21. The evaluation was made in the same manner as Examples 5 and 6 with reference to the evaluation results of Comparison Example 7.

The electrophotographic photosensitive member fabricated in Example 7 showed satisfactory results in all the evaluation items.

Table 21

|  | Unevenness of Image Density | Photomemory | Variation of Properties | Image Defect |
|---|---|---|---|---|
| Example 7 | AA | AA | AA | AA - A |

As described above, according to the present invention, in a plasma processing method and a plasma processing apparatus for processing an object to be processed, which is placed in a reactor container, by decomposing a raw material gas introduced into the reactor container using a high frequency power outputted from a high power supply and introduced into the reactor container via a matching device and an electrode, the adjustment of impedance by the matching device during plasma processing is carried out within a predetermined impedance variable range, and the impedance variable range is changed as plasma processing proceeds, whereby the adjustment of impedance by the matching device is accomplished properly and stably, thus making it possible to achieve the improvement of plasma processing characteristics, the improvement of reproducibility of plasma processing characteristics and reduction in costs for plasma processing.

In a plasma processing method for processing an object to be processed, which is placed in a reactor container, by decomposing a raw material gas in the reactor container using a high frequency power outputted from a high power supply and introduced into the reactor container via a matching device and an electrode, the adjustment of impedance by the matching device during plasma processing is controlled within a predetermined impedance variable range, and the impedance variable range is changed as plasma processing proceeds. Another plasma processing method employing a plurality of power supply systems having high frequency power supplies and matching devices capable of changing impedances. A plasma processing apparatus using a plurality of power supply systems having matching circuits capable of changing impedances and control systems for controlling the impedances of the matching circuits.

**Claims**

1. A plasma processing method comprising

   (a) introducing a high frequency power outputted from a high frequency power supply into a reactor container via a matching device including a matching circuit and an electrode;
   (b) decomposing a raw material gas introduced into said reactor container by means of the high frequency power; and
   (c) processing an object to be processed which is placed in the reactor container,
   **characterized by**
   (d) controlling the adjustment of impedance by said matching device during plasma processing by adjusting the impedance of the matching circuit within a predetermined impedance variable range, said impedance variable range being determined independently of a variable width of impedance variable elements constituting the matching circuit; and
   (e) changing the impedance variable range as plasma processing proceeds.

2. The plasma processing method according to claim 1, wherein the impedance variable range is substantially continuously changed as plasma processing proceeds.

3. The plasma processing method according to claim 1 or 2, wherein the adjustment of impedance by said matching device is carried out with automatic control.

4. The plasma processing method according to claim 3, wherein the automatic control is accomplished by adjusting the impedance of the matching device so that preset matching goal conditions are satisfied, and the matching goal conditions are changed as plasma processing proceeds.

5. The plasma processing method according to claim 4, wherein the matching goal conditions are substantially continuously changed as plasma processing proceeds.

6. The plasma processing method according to any one of claims 1 to 5, wherein the frequency of high frequency power is not lower than 50 MHz, and not higher than 250 MHz.

7. The plasma processing method according to any one of claims 1 to 6, wherein the plasma processing is performed by continuously carrying out a plurality of processes with different conditions.

8.  The plasma processing method according to any one of claims 1 to 7, wherein the object to be processed is moved or rotated at least during one period in the plasma processing.

9.  The plasma processing method according to any one of claims 1 to 8, wherein the plasma

10. The plasma processing method according to claim 1, **characterized in that** said changing of the impedance variable range as plasma processing proceeds is performed for each of processes with different plasma processing conditions

11. A plasma processing method comprising

    (a) introducing high frequency powers into a reactor container via electrodes from a plurality of power supply systems having high frequency power supplies and matching devices including matching circuits capable of changing impedances;
    (b) decomposing a raw material gas introduced into said reactor container by means of said high frequency powers; and
    (c) plasma processing a substrate to be processed which is placed in the reactor container,
    **characterized by**
    (d) carrying out adjustment of impedance by at least one matching device of said matching devices of said plurality of power supply systems during plasma processing with automatic control by adjusting the impedance of the matching circuit of the at least one matching device within a predetermined impedance variable range, said impedance variable range being determined independently of a variable width of impedance variable elements constituting the matching circuit.

12. The plasma processing method according to claim 11, wherein the adjustment of impedance by said matching device during plasma processing is carried out with automatic control within said predetermined variable range in all said matching devices.

13. The plasma processing method according to claim 11 or 12, wherein high frequency powers of different frequencies are supplied to said reactor container at the same time.

14. The plasma processing method according to any one of claims 11 to 13, wherein a plurality of high frequency powers are supplied to said reactor container from the same said electrode at the same time.

15. The plasma processing method according to claim 13 or 14, wherein said plurality of power supply systems supply two types of high frequency powers with frequencies of not lower than 10 MHz and not higher than 250 MHz respectively, and assuming that, of the two types of high frequency powers, the frequency of the high frequency power having a higher frequency is represented by $f_1$, and the frequency of the high frequency power having a lower frequency is represented by $f_2$, a frequency ratio between $f_1$ and $f_2$ satisfies the condition of:

$$0.1 \leq f_2/f_1 \leq 0.9$$

16. The plasma processing method according to claim 15, wherein said two types of high frequency powers satisfy the condition of:

$$0.5 < f_2/f_1 \leq 0.9$$

17. The plasma processing method according to any one of claims 11 to 16, wherein said impedance variable range is changed as plasma processing proceeds.

18. The plasma processing method according to any one of claims 11 to 17, wherein said automatic control is accomplished by adjusting the impedance of said matching device so that the preset matching goal conditions are satisfied, and changing said matching goal conditions as plasma processing proceeds.

**19.** The plasma processing method according to any one of claims 11 to 18, wherein at least one of said impedance variable range and the preset matching goal conditions is continuously changed as said plasma processing proceeds.

**20.** The plasma processing method according to any one of claims 11 to 19, wherein said plasma processing is performed by continuously carrying out a plurality of processes with different conditions.

**21.** The plasma processing method according to any one of claims 11 to 20, wherein said substrate to be processed is moved or rotated at least during one period in said plasma processing.

**22.** The plasma processing method according to any one of claims 11 to 21, wherein an electrophotographic photosensitive member is formed by said plasma processing.

**23.** The plasma processing method according to claim 11, **characterized in that** said preset impedance variable range is changed for each of processes with different plasma processing conditions.

**24.** A plasma processing apparatus comprising
a reactor container (601, 701) for plasma processing a substrate (605, 705) to be processed,
raw material gas supplying means (612, 710) for supplying a raw material gas to said reactor container, and
a plurality of power supply systems (603, 615, 711, 713) for supplying high frequency powers to said reactor container,
**characterized in that**
said plurality of power supply systems have matching circuits (604, 616, 712, 714) capable of changing impedances and control systems (100a, 100b) for controlling the impedances of said matching circuits by adjusting the impedances of the matching circuits, said control system being capable of storing a variable range setting value for limiting an impedance variable range.

**25.** The plasma processing apparatus according to claim 24, wherein said control system can store a plurality of said variable range setting values.

**26.** The plasma processing apparatus according to claim 24 or 26, wherein said control system can store a matching goal condition for determining whether matching is obtained or not.

**27.** The plasma processing apparatus according to claim 26, wherein said control system can store a plurality of said matching goal conditions.

**Patentansprüche**

**1.** Verfahren zur Plasmabearbeitung, mit den Verfahrensschritten:

(a) Einleiten von Hochfrequenzleistung aus einer Hochfrequenzlieferquelle über eine Anpaßeinrichtung mit einer Anpaßschaltung und einer Elektrode in ein Reaktionsgefäß;
(b) Zersetzen eines in das Reaktorgefäß eingeführten Ausgangsgases durch die Hochfrequenzleistung; und
(c) Verarbeiten eines zu bearbeitenden Gegenstands, der sich im Reaktionsgefäß befindet;
**gekennzeichnet durch**
(d) Steuern des Einstellens der Impedanz während der Plasmabearbeitung von der Anpaßeinrichtung **durch** Einstellen der Impedanz der Anpaßschaltung innerhalb eines vorbestimmten impedanzvariablen Bereichs, der unabhängig von einer variablen Breite impedanzvariabler Elemente bestimmt ist, die die Anpaßschaltung bilden; und **durch**
(e) Verändern des impedanzvariablen Bereichs mit Fortschreiten der Plasmabearbeitung.

**2.** Verfahren zur Plasmabearbeitung nach Anspruch 1, bei dem der impedanzvariable Bereich im wesentlichen kontinuierlich mit dem Fortschreiten der Plasmabearbeitung verändert wird.

**3.** Verfahren zur Plasmabearbeitung nach Anspruch 1 oder 2, bei dem das Einstellen der Impedanz durch die Anpaßeinrichtung mit automatischer Steuerung erfolgt.

**4.** Verfahren zur Plasmabearbeitung nach Anspruch 3, bei dem die automatische Steuerung durch Einstellen der Impedanz der Anpaßeinrichtung so erfolgt, daß voreingestellten Zielanpaßbedingungen genügt wird und daß die Zielanpaßbedingungen mit dem Fortschreiten der Plasmabearbeitung verändert werden.

5. Verfahren zur Plasmabearbeitung nach Anspruch 4, bei dem die Zielanpaßbedingungen im wesentlichen kontinuierlich mit dem Fortschreiten der Plasmabearbeitung verändert werden.

6. Verfahren zur Plasmabearbeitung nach einem der Ansprüche 1 bis 5, bei dem die Frequenz der Hochfrequenzleistung nicht unter 50 MHz und nicht über 250 MHz liegt.

7. Verfahren zur Plasmabearbeitung nach einem der Ansprüche 1 bis 6, bei dem die Plasmabearbeitung durch kontinuierliches Ausführen einer Vielzahl von Verarbeitungen unter verschiedenen Bedingungen erfolgt.

8. Verfahren zur Plasmabearbeitung nach einem der Ansprüche 1 bis 7, bei dem der zu verarbeitende Gegenstand wenigstens während einer Periode in der Plasmabearbeitung verschoben oder gedreht wird.

9. Verfahren zur Plasmabearbeitung nach einem der Ansprüche 1 bis 8, bei dem die Plasmabearbeitung zum Bilden eines elektrophotographischen photoempfindlichen Glieds erfolgt.

10. Verfahren zur Plasmabearbeitung nach Anspruch 1, **dadurch gekennzeichnet, daß** das Ändern des impedanzvariablen Bereichs mit dem Fortschreiten der Plasmabearbeitung für alle Prozesse unter verschiedenen Plasmabearbeitungsbedingungen erfolgt.

11. Verfahren zur Plasmabearbeitung, mit den Verfahrensschritten:

(a) Einleiten von Hochfrequenzleistungen aus einer Vielzahl von Stromnetzen mit Hochfrequenzliefer- und impedanzvariablen Anpaßeinrichtungen mit Anpaßschaltungen über Elektroden in ein Reaktionsgefäß;
(b) Zersetzen eines in das Reaktionsgefäß eingeführten Ausgangsgases mit den Hochfrequenzleistungen; und
(c) Plasmabearbeitung eines zu verarbeitenden Substrats, das sich im Reaktionsgefäß befindet,
**gekennzeichnet durch**
(d) Ausführen einer Impedanzeinstellung **durch** wenigstens eine Anpaßeinrichtung der Anpaßeinrichtungen der Vielzahl von Stromnetzen während der Plasmabearbeitung mit automatischer Steuerung **durch** Justieren der Impedanz der Anpaßschaltung wenigstens einer Anpaßeinrichtung innerhalb eines vorbestimmten impedanzvariablen Bereichs, der unabhängig von einer variablen Breite impedanzvariabler Elemente bestimmt ist, die die Anpaßschaltung bilden.

12. Verfahren zur Plasmabearbeitung nach Anspruch 11, bei dem die Impedanz von der Anpaßeinrichtung während der Plasmabearbeitung mit automatischer Steuerung innerhalb des vorbestimmten variablen Bereichs in allen Anpaßeinrichtungen erfolgt.

13. Verfahren zur Plasmabearbeitung nach Anspruch 11 oder 12, bei dem die Hochfrequenzleistungen der unterschiedlichen Frequenzen gleichzeitig dem Reaktionsgefäß zugeführt werden.

14. Verfahren zur Plasmabearbeitung nach einem der Ansprüche 11 bis 13, bei dem die Vielzahl der Hochfrequenzleistungen gleichzeitig aus derselben Elektrode dem Reaktionsgefäß zugeführt werden.

15. Verfahren zur Plasmabearbeitung nach Anspruch 13 oder 14, bei dem die Vielzahl von Stromnetzen zwei Arten von Hochfrequenzleistungen mit Frequenzen liefert, die nicht unter 10 MHz beziehungsweise nicht über 250 MHz liegen, und wobei angenommen wird, daß von den beiden Arten der Hochfrequenzleistungen die Frequenz der Hochfrequenzleistung mit höherer Frequenz durch $f_1$ und die Frequenz der Hochfrequenzleistung mit niedrigerer Frequenz durch $f_2$ dargestellt wird und daß ein Frequenzverhältnis zwischen $f_1$ und $f_2$ folgender Beziehung genügt:

$$0,1 \leq f_2/f_1 \leq 0,9.$$

16. Verfahren zur Plasmabearbeitung nach Anspruch 15, bei dem die beiden Arten der Hochfrequenzleistungen folgender Beziehung genügen:

$$0,5 < f_2/f_1 \le 0,9.$$

**17.** Verfahren zur Plasmabearbeitung nach einem der Ansprüche 11 bis 16, bei dem der impedanzvariable Bereich mit Fortschreiten der Plasmabearbeitung verändert wird.

**18.** Verfahren zur Plasmabearbeitung nach einem der Ansprüche 11 bis 17, bei dem die automatische Steuerung durch Justieren der Impedanz der Anpaßeinrichtung so erfolgt, daß den voreingestellten Zielbedingungen genügt wird und die Zielanpaßbedingungen mit Fortschreiten der Plasmabearbeitung verändert werden.

**19.** Verfahren zur Plasmabearbeitung nach einem der Ansprüche 11 bis 16, bei dem wenigstens entweder der impedanzvariable Bereich oder die Voreinstellzielanpaßbedingungen stetig mit Fortschreiten der Plasmabearbeitung verändert wird.

**20.** Verfahren zur Plasmabearbeitung nach einem der Ansprüche 11 bis 19, bei dem die Plasmabearbeitung durch kontinuierliches Ausführen einer Vielzahl von Prozessen unter verschiedenen Bedingungen erfolgt.

**21.** Verfahren zur Plasmabearbeitung nach einem der Ansprüche 11 bis 20, bei dem das zu verarbeitende Substrat wenigstens während einer Periode der Plasmabearbeitung eine Verschiebung oder Drehung erfährt.

**22.** Verfahren zur Plasmabearbeitung nach einem der Ansprüche 11 bis 21, bei dem ein elektrophotographisches lichtempfindliches Glied durch die Plasmabearbeitung gebildet wird.

**23.** Verfahren zur Plasmabearbeitung nach Anspruch 11, **dadurch gekennzeichnet, daß** der voreingestellte impedanzvariable Bereich für jeden der Prozesse unter unterschiedlichen Plasmabearbeitungsbedingungen verändert wird.

**24.** Vorrichtung zur Plasmabearbeitung mit
einem Reaktionsgefäß (601, 701) zur Plasmabearbeitung eines zu bearbeitenden Substrats (605,150),
einem Mittel (612, 710) zum Liefern eines Ausgangsgases in das Reaktionsgefäß, und mit
einer Vielzahl von Stromnetzen (603, 615, 711, 713) zum Beliefern des Reaktionsgefäßes mit Hochfrequenzleistungen,
**dadurch gekennzeichnet, daß**
die Vielzahl der Stromnetze Anpaßschaltungen (604, 616, 712, 714) besitzen, die in der Lage sind, Impedanzen und Steuersysteme (100a, 100b) zum Steuern der Impedanzen der Anpaßschaltungen zu verändern, um die Impedanzen der Anpaßschaltungen durch Einstellen zu steuern, wobei das Steuersystem in der Lage ist, einen variablen Bereichseinstellwert zur Begrenzung eines impedanzvariablen Bereichs zu speichern.

**25.** Vorrichtung zur Plasmabearbeitung nach Anspruch 24, deren Steuersystem eine Vielzahl variabler Bereichseinstellwerte speichern kann.

**26.** Vorrichtung zur Plasmabearbeitung nach Anspruch 24 oder 25, deren Steuersystem eine Zielanpaßbedingung zum Bestimmen speichern kann, ob die Anpassung erzielt ist.

**27.** Vorrichtung zur Plasmabearbeitung nach Anspruch 26, deren Steuersystem eine Vielzahl der Zielanpaßbedingungen speichern kann.

**Revendications**

**1.** Procédé de traitement au plasma comprenant

(a) l'introduction d'une énergie à haute fréquence délivrée en sortie d'une alimentation en énergie à haute fréquence dans une enceinte de réacteur par l'intermédiaire d'un dispositif d'adaptation comprenant un circuit d'adaptation et une électrode ;
(b) la décomposition d'un gaz de matière brut introduit dans ladite enceinte de réacteur au moyen de l'énergie à haute fréquence ; et

(c) le traitement d'un objet devant être traité qui est placé dans l'enceinte du réacteur,
**caractérisé par**
(d) la commande du réglage d'impédance par ledit dispositif d'adaptation pendant un traitement au plasma par réglage de l'impédance du circuit d'adaptation, dans une plage variable d'impédance prédéterminée, ladite plage variable d'impédance étant déterminée indépendamment d'une largeur variable d'éléments variables d'impédance constituant le circuit d'adaptation ; et
(e) la modification de la plage variable d'impédance au fur et à mesure du déroulement du traitement au plasma.

**2.** Procédé de traitement au plasma selon la revendication 1, dans lequel la plage variable d'impédance est modifiée de façon sensiblement continue au fur et à mesure du déroulement du traitement au plasma.

**3.** Procédé de traitement au plasma selon la revendication 1 ou 2, dans lequel le réglage de l'impédance par ledit dispositif d'adaptation est exécuté à l'aide d'une commande automatique.

**4.** Procédé de traitement au plasma selon la revendication 3, dans lequel la commande automatique est réalisée par un réglage de l'impédance du dispositif d'adaptation afin que des conditions de consigne d'adaptation préalablement établies soient satisfaites, et les conditions de consigne d'adaptation sont modifiées au fur et à mesure du déroulement du traitement au plasma.

**5.** Procédé de traitement au plasma selon la revendication 4, dans lequel les conditions de consigne d'adaptation sont modifiées de manière sensiblement continue au fur et à mesure du déroulement du traitement au plasma.

**6.** Procédé de traitement au plasma selon l'une quelconque des revendications 1 à 5, dans lequel la fréquence de l'énergie à haute fréquence n'est pas inférieure à 50 MHz ni supérieure à 250 MHz.

**7.** Procédé de traitement au plasma selon l'une quelconque des revendications 1 à 6, dans lequel le traitement au plasma est effectué en exécutant en continu plusieurs processus avec des conditions différentes.

**8.** Procédé de traitement au plasma selon l'une quelconque des revendications 1 à 7, dans lequel l'objet devant être traité est déplacé ou tourné au moins pendant une période lors du traitement au plasma.

**9.** Procédé de traitement au plasma selon l'une quelconque des revendications 1 à 8, dans lequel le traitement au plasma est exécuté pour former un élément photosensible électrophotographique.

**10.** Procédé de traitement au plasma selon la revendication 1, **caractérisé en ce que** ladite modification de la plage variable d'impédance au fur et à mesure du déroulement du traitement au plasma est effectuée pour chacun des processus avec différentes conditions de traitement au plasma.

**11.** Procédé de traitement au plasma comprenant

(a) l'introduction d'énergies à haute fréquence dans une enceinte de réacteur par l'intermédiaire d'électrodes depuis plusieurs systèmes d'alimentation en énergie ayant des alimentations en énergie à haute fréquence et de dispositifs d'adaptation comprenant des circuits d'adaptation capables de modifier des impédances ;
(b) la décomposition d'un gaz de matière brut introduit dans ladite enceinte de réacteur au moyen desdites énergies à haute fréquence ; et
(c) le traitement au plasma d'un substrat devant être traité qui est placé dans l'enceinte de réacteur,
**caractérisé par**
(d) l'exécution d'un réglage d'impédance par au moins un dispositif d'adaptation desdits dispositifs d'adaptation de ladite pluralité de systèmes d'alimentation en énergie pendant un traitement au plasma avec une commande automatique par un réglage de l'impédance du circuit d'adaptation du, au moins un, dispositif d'adaptation dans une plage variable d'impédance prédéterminée, ladite plage variable d'impédance étant déterminée indépendamment d'une largeur variable d'éléments variables d'impédance constituant le circuit d'impédance.

**12.** Procédé de traitement au plasma selon la revendication 11, dans lequel le réglage de l'impédance par ledit dispositif d'adaptation pendant un traitement au plasma est effectué à l'aide d'une commande automatique dans ladite plage variable prédéterminée dans tous lesdits dispositifs d'adaptation.

**13.** Procédé de traitement au plasma selon la revendication 11 ou 12, dans lequel les énergies à haute fréquence de différentes fréquences sont fournies en même temps à ladite enceinte du réacteur.

**14.** Procédé de traitement au plasma selon l'une quelconque des revendications 11 à 13, dans lequel plusieurs énergies à haute fréquence sont fournies en même temps à ladite enceinte du réacteur depuis la même dite électrode.

**15.** Procédé de traitement au plasma selon la revendication 13 ou 14, dans lequel lesdits plusieurs systèmes d'alimentation en énergie fournissent deux types d'énergies à haute fréquence ayant des fréquences non inférieures à 10 MHz ni supérieures à 250 MHz, respectivement, et, en supposant que, des deux types d'énergies à haute fréquence, la fréquence de l'énergie à haute fréquence ayant une fréquence plus élevée est représentée par $f_1$, et la fréquence de l'énergie à haute fréquence ayant une fréquence plus basse est représentée par $f_2$, un rapport de fréquence entre $f_1$ et $f_2$ satisfait à la condition:

$$0,1 \leq f_2/f_1 \leq 0,9$$

**16.** Procédé de traitement au plasma selon la revendication 15, dans lequel lesdits deux types d'énergies à haute fréquence satisfont à la condition :

$$0,5 \leq f_2/f_1 \leq 0,9$$

**17.** Procédé de traitement au plasma selon l'une quelconque des revendications 11 à 16, dans lequel ladite plage variable d'impédance est modifiée au fur et à mesure du déroulement du traitement au plasma.

**18.** Procédé de traitement au plasma selon l'une quelconque des revendications 11 à 17, dans lequel ladite commande automatique est réalisée en réglant l'impédance dudit dispositif d'adaptation afin que les conditions de consigne d'adaptation préalablement établies soient satisfaites, et en modifiant lesdites conditions de consigne d'adaptation au fur et à mesure du déroulement du traitement au plasma.

**19.** Procédé de traitement au plasma selon l'une quelconque des revendications 11 à 18, dans lequel au moins l'une de ladite plage variable d'impédances et des conditions de consigne d'adaptation préétablies est modifiée en continu pendant le déroulement dudit traitement au plasma.

**20.** Procédé de traitement au plasma selon l'une quelconque des revendications 11 à 19, dans lequel le traitement au plasma est réalisé en exécutant en continu plusieurs processus avec des conditions différentes.

**21.** Procédé de traitement au plasma selon l'une quelconque des revendications 11 à 20, dans lequel ledit substrat devant être traité est déplacé ou tourné pendant au moins une période dans ledit traitement au plasma.

**22.** Procédé de traitement au plasma selon l'une quelconque des revendications 11 à 21, dans lequel un élément photosensible électrophotographique est formé par ledit traitement au plasma.

**23.** Procédé de traitement au plasma selon la revendication 11, **caractérisé en ce que** ladite plage variable d'impédances préétablie est modifiée pour chacun des processus avec différentes conditions de traitement au plasma.

**24.** Appareil de traitement au plasma comportant
une enceinte de réacteur (601, 701) pour un traitement au plasma d'un substrat (605, 705) devant être traité,
un moyen (612, 710) d'alimentation en gaz de matière brut pour fournir un gaz de matière brut à ladite enceinte du réacteur, et
une pluralité de systèmes (603, 615, 711, 713) d'alimentation en énergie destinés à fournir des énergies à haute fréquence à ladite enceinte du réacteur,
**caractérisé en ce que**
ladite pluralité de systèmes d'alimentation en énergie comportent des circuits d'adaptation (604, 616, 712, 714) capables de modifier des impédances et des systèmes de commande (100a, 100b) destinés à commander les impédances desdits circuits d'adaptation par un réglage des impédances des circuits d'adaptation, ledit système de commande étant capable de stocker une valeur d'établissement d'une plage variable pour limiter une plage variable d'impédances.

**25.** Appareil de traitement au plasma selon la revendication 24, dans lequel ledit système de commande peut stocker plusieurs desdites valeurs d'établissement de plage variable.

**26.** Appareil de traitement au plasma selon la revendication 24 ou 25, dans lequel ledit système de commande peut stocker une condition de consigne d'adaptation pour déterminer si une adaptation est obtenue ou non.

**27.** Appareil de traitement au plasma selon la revendication 26, dans lequel ledit système de commande peut stocker plusieurs desdites conditions de consigne d'adaptation.

# FIG. 1

# FIG. 2A

# FIG. 2B

# FIG. 3

## FIG. 4A

## FIG. 4B

## FIG. 5

# FIG. 6A

603

604

602      612      601

605

607

6B — · — · —                                     — · — 6B

614

608

611

616

615

# FIG. 6B

601      607      605

602

611

614

612

## FIG. 7A

## FIG. 7B